# EUROPEAN PATENT SPECIFICATION

(11) **EP 3 226 318 B1**
(45) Date of publication and mention of the grant of the patent: **17.04.2019**
(21) Application number: 15879731.6
(22) Date of filing: 16.12.2015
(51) Int. Cl.: H01L 51/54, H01L 51/50, C09K 11/06

(54) **THERMALLY-ACTIVATED SENSITIZED PHOSPHORESCENT ORGANIC ELECTROLUMINESCENT DEVICE**
THERMISCH AKTIVIERTES SENSIBILISIERTES PHOSPHORESZIERENDES ORGANISCHES ELEKTROLUMINESZENTES BAUELEMENT
DISPOSITIF ÉLECTROLUMINESCENT ORGANIQUE PHOSPHORESCENT SENSIBILISÉ THERMIQUEMENT ACTIVÉ

(30) Priority: 26.01.2015 CN 201510037898
(43) Date of publication of application: 04.10.2017
(73) Proprietor: Beijing Visionox Technology Co., Ltd., Beijing 100085 (CN); Tsinghua University, Haidian District Beijing 100084 (CN)
(72) Inventor: DUAN, Lian, Beijing 100085 (CN); XIE, Jing, Beijing 100085 (CN); LIU, Song, Beijing 100085 (CN); ZHANG, Dongdong, Beijing 100085 (CN); ZHAO, Fei, Beijing 100085 (CN)
(74) Representative: Hanna Moore + Curley
(86) International application number: PCT/CN2015/097529
(87) International publication number: WO 2016/119533

(56) References cited:
- WO-A1-2014/002629
- WO-A1-2014/157610
- WO-A1-2014/163083
- WO-A1-2014/166585
- WO-A1-2014/194971
- US-A1- 2013 207 088
- ZHANG, DONGDONG ET AL.: 'Extremely low driving voltage electrophosphorescent green organic light-emitting diodes based on a host material with small singlet-triplet exchange energy without p- or n-doping layer' ORGANIC ELECTRONICS vol. 14, no. 1, 31 January 2013, pages 260 - 266, XP055392019

## Description

### TECHNICAL FIELD

The present invention relates to the field of organic electroluminescence devices, and particularly to a thermally activated and sensitized phosphorescence organic electroluminescence device.

### BACKGROUND OF THE PRESENT INVENTION

Presently, in the prior art, the luminescent layers of organic electroluminescence devices are generally formed by a host material doped by a dye. The conventional double host luminescent layers are formed by two hosts doped by a dye (fluorescence or phosphorescence). The host materials of such double host luminescent layers do not have thermally delayed fluorescence effect, and the dye does not have thermally delayed fluorescence characteristics either.

In the conditions of electric excitation, organic electroluminescence devices generate 25% of singlet state excitons and 75% of triplet state excitons. The conventional fluorescence materials can only utilize the 25% of the singlet state excitons due to spin forbidding, so the external quantum efficiency is limited to merely below 5%. Nearly all of the triplet state excitons can only be lost in the form of heat. In order to improve the efficiency of organic electroluminescence devices, the triplet state excitons must be sufficiently utilized.

In order to utilize the triplet state excitons, researchers have proposed many methods. What is the most significant is the utilization of phosphorescence materials. Because heavy atoms are introduced into phosphorescence materials, which results in spin-orbit coupling effect, the 75% of triplet state excitons can be sufficiently utilized, thereby achieving 100% of internal quantum efficiency. However, because phosphorescence materials use rare heavy metals, the raw materials are expensive, which is adverse to reduce the product cost. If fluorescence devices can well utilize the triplet state excitons, the problem will be solved satisfactorily. Researchers proposed generating the singlet state in fluorescence devices by using triplet state quenching to improve the efficiency of the fluorescence devices, but the maximum external quantum efficiency that the method can theoretically reach is merely 62.5%, which is far below that of phosphorescence materials. Therefore, to seek a new technique to sufficiently utilize the triplet state energy level of fluorescence materials to improve the luminescence efficiency is highly necessary.

Adachi et, al. of Kyushu University proposed a new approach to achieve high efficiency fluorescence OLED: thermally activated delayed fluorescence (TADF) materials. The energy gap between singlet state and triplet state (ΔE_{ST}) of this type of materials is very small, and the triplet state excitons, which cannot emit light, can be upconverted to singlet state excitons, which can emit light, under the effect of environmental heat. However, when this type of materials directly serve as the luminescent layer, the devices have a long way to go before practical utilization, with efficiency not high enough, short life, and severe roll-off.

The thermally activated and sensitized luminescence mechanism utilizes a thermally activated delayed fluorescence material as the host and a phosphorescence material as the dye, and can achieve devices of high efficiency, low voltage and long life. That is because in the conventional thermally delayed fluorescence, the energy conversion and the luminescence are within the same single material, while regarding the thermally activated and sensitized devices, the energy conversion and the luminescence are conducted by different materials. That can ensure the sufficient utilization of the triplet state energy, lift the efficiency, reduce the problem of roll-off under high luminance, and prolong the device life.

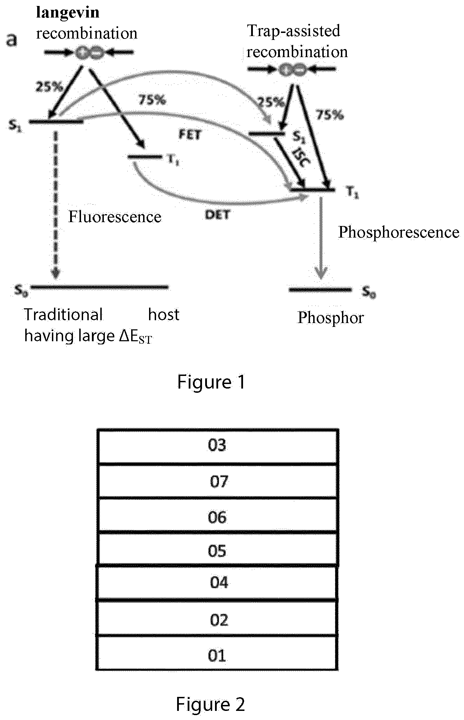

As shown by Fig. 1, after electrons and holes undergo langevin recombination in an organic molecule, due to the difference in the electron spin symmetry modes, two excited state forms, a single excited state and a triplet excited state, are generated. In the host and guest luminophor system of phosphorescence devices, there are two luminescence mechanisms, energy transfer and trap-assisted mode. The energy transfer comprises long range Forster transfer mode and short range Dexter transfer mode. The trap-assisted mode is by the electrons and the holes directly recombining on the guest luminophor into excitons and in turn exciting the guest luminophor to emit light. In the conventional phosphorescence doping systems, the energy transfer from the triplet state of the host to the triplet state of the guest can only be via the short range Dexter energy transfer, and in order to reduce the distance between the host and the guest and promote the complete transfer of energy, a high doping concentration of the phosphorescence is required (15-20wt%). That will result in high cost, and will cause the degrading of the device efficiency.

The relevant state of the art is represented by WO 2014/157610 A1.

### TECHNICAL PROBLEMS

The organic electroluminescence devices of the prior art are formed by a host material doped by a dye, which has high cost, and will cause the degrading of the device efficiency.

### TECHNICAL SOLUTION

The present teaching provides a thermally activated and sensitized phosphorescence organic electroluminescence device as detailed in claim 1.

### Advantageous features are provided in dependent claims

The present invention discloses a thermally activated and sensitized phosphorescence organic electroluminescence device, comprising a luminescent layer, wherein the host material of the luminescent layer consists of two materials, wherein one of the two materials is a hole transport material, the other is an electron transport material, and both of the two materials are thermally activated delayed fluorescence materials; and the host material is doped by a phosphorescent dye, and a proportion of the phosphorescent dye in the luminescent layer is <15wt%, and
the triplet state energy level of the CT excited state of the thermally activated delayed fluorescence material is higher than the triplet state energy level of the n-π excited state by 0 to 0.3; or, the triplet state energy level of the CT excited state of the thermally activated delayed fluorescence material is higher than the triplet state energy level of the n-π excited state, wherein the difference is above 1.0eV, and, a difference between the second triplet state energy level of its n-π excited state and the first singlet state energy level of its CT excited state is-0.1 to 0.1 eV.

Preferably, the proportion of the phosphorescent dye in the luminescent layer is 2wt%-10wt%, more preferably 2wt%-3wt%.

Preferably, the thermally activated delayed fluorescence material is a material that has charge transfer transition, and the thermally activated delayed fluorescence material has both a donor group unit and an acceptor group unit therein,
the donor group unit is a donor group or a group that is formed by linking two or more donor groups;
the acceptor group unit is an acceptor group or a group that is formed by linking two or more acceptor groups;
the donor group is selected from indolocarbazolyl; carbazolyl; bicarbazolyl; trianilino; phenoxazinyl; indolocarbazolyl that is substituted by one or more groups of C₁₋₆ alkyl, methoxy, ethoxy or phenyl; carbazolyl that is substituted by one or more groups of C₁₋₆ alkyl, methoxy, ethoxy or phenyl; bicarbazolyl that is substituted by one or more groups of C₁₋₆ alkyl, methoxy, ethoxy or phenyl; trianilino that is substituted by one or more groups of C₁₋₆ alkyl, methoxy, ethoxy or phenyl; or phenoxazinyl that is substituted by one or more groups of C₁₋₆ alkyl, methoxy, ethoxy or phenyl; and
the acceptor group is selected from naphthyl; anthryl; phenanthryl; pyrenyl; triazinyl; benzimidazolyl; cyano; pyridinyl; sulfonyl; phenanthroimidazolyl; naphthathiazolyl; benzothiazolyl; oxadiazolyl; naphthyl that is substituted by one or more groups of C₁₋₆ alkyl, methoxy, ethoxy, phenyl or pyridinyl; anthryl that is substituted by one or more groups of C₁₋₆ alkyl, methoxy, ethoxy, phenyl or pyridinyl, phenanthryl that is substituted by one or more groups of C₁₋₆ alkyl, methoxy, ethoxy, phenyl or pyridinyl; pyrenyl that is substituted by one or more groups of C₁₋₆ alkyl, methoxy, ethoxy, phenyl or pyridinyl; triazinyl that is substituted by one or more groups of C₁₋₆ alkyl, methoxy, ethoxy, phenyl or pyridinyl; benzimidazolyl that is substituted by one or more groups of C₁₋₆ alkyl, methoxy, ethoxy, phenyl or pyridinyl; pyridinyl that is substituted by one or more groups of C₁₋₆ alkyl, methoxy, ethoxy, phenyl or pyridinyl; sulfonyl that is substituted by one or more groups of C₁₋₆ alkyl, methoxy, ethoxy, phenyl or pyridinyl; phenanthroimidazolyl that is substituted by one or more groups of C₁₋₆ alkyl, methoxy, ethoxy, phenyl or pyridinyl; naphthathiazolyl that is substituted by one or more groups of C₁₋₆ alkyl, methoxy, ethoxy, phenyl or pyridinyl; benzothiazolyl that is substituted by one or more groups of C₁₋₆ alkyl, methoxy, ethoxy, phenyl or pyridinyl; and oxadiazolyl that is substituted by one or more groups of C₁₋₆ alkyl, methoxy, ethoxy, phenyl or pyridinyl;
wherein, one or more of the donor group unit and one or more of the acceptor group unit directly link to form the thermally activated delayed fluorescence material; or, one or more of the donor group unit and one or more of the acceptor group unit individually link to a linking group to form the thermally activated delayed fluorescence material, wherein the linking group is a group that has a steric hindrance.

Preferably, one or two of the donor group units and one or two of the acceptor group units individually link to the linking group to form the thermally activated delayed fluorescence material, or one or two of the acceptor group units and one or two of the donor group units directly link to form the thermally activated delayed fluorescence material.

Preferably, the linking group is selected from spirofluorenyl, phenyl, biphenyl, spirofluorenyl that is substituted by at least one of C₁₋₆ alkyl or phenyl, phenyl that is substituted by at least one of C₁₋₆ alkyl or phenyl, and biphenyl that is substituted by at least one of C₁₋₆ alkyl or phenyl.

Preferably, the donor group is selected from the following groups:

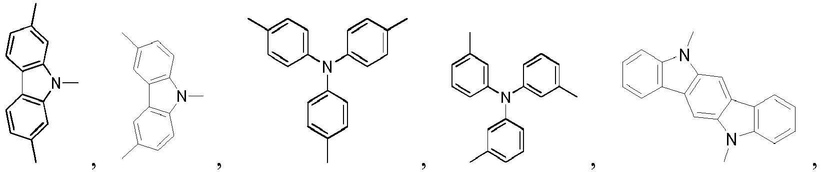

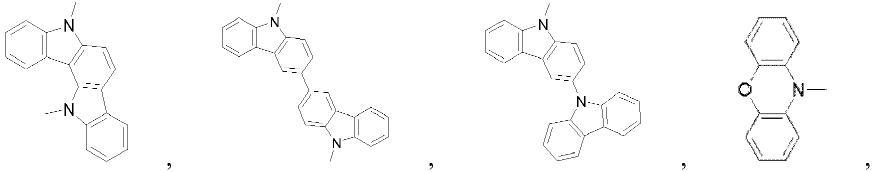

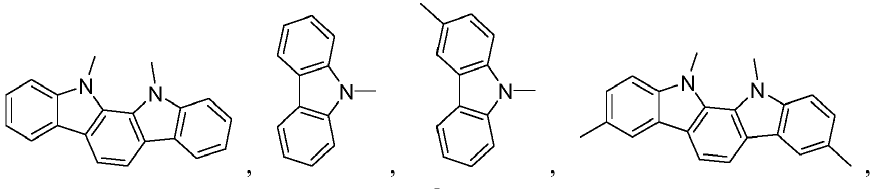

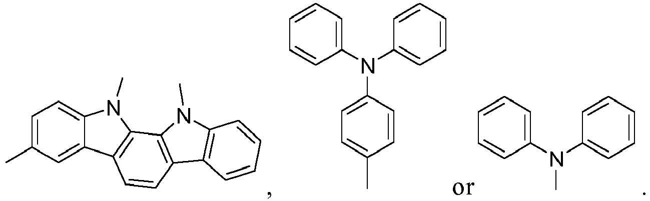

Preferably, the acceptor group is selected from the following groups:

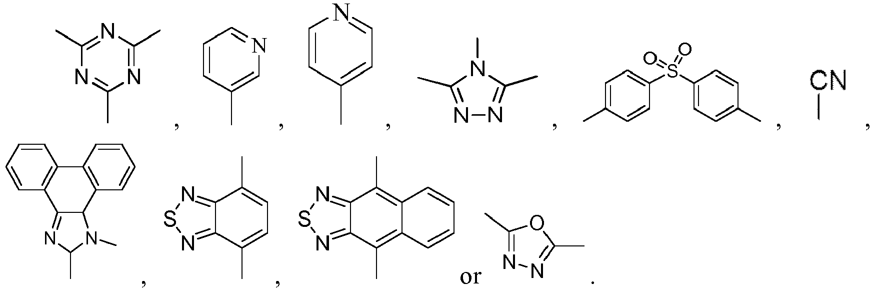

Preferably, the thermally activated delayed fluorescence material is a compound that has the following structures:

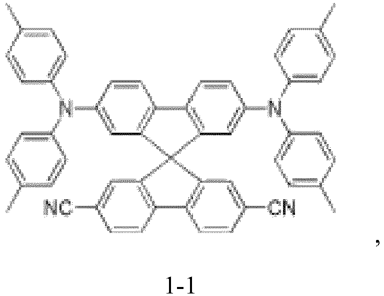

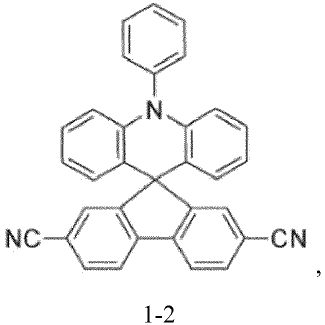

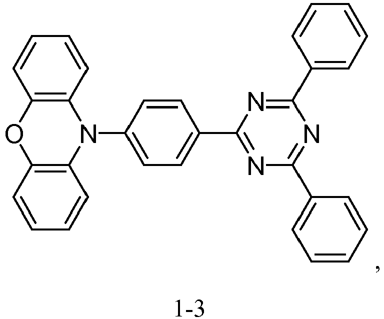

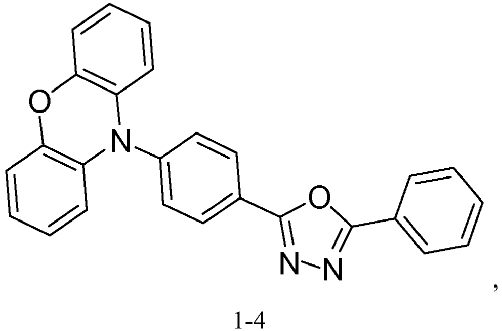

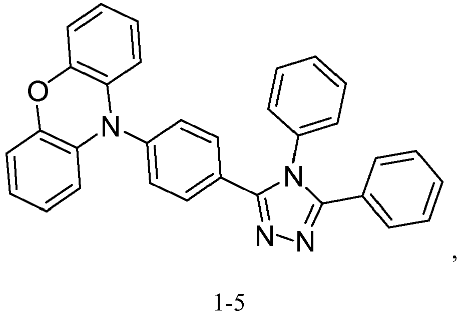

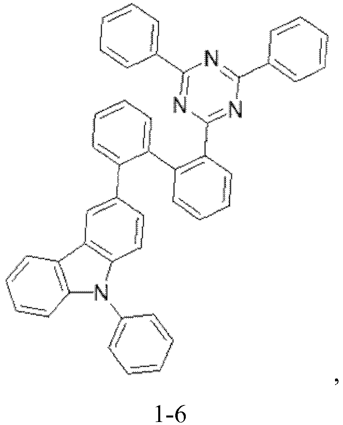

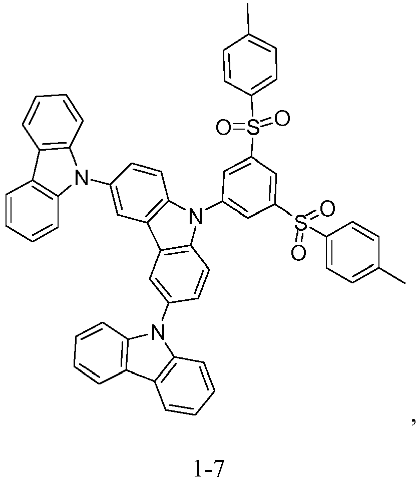

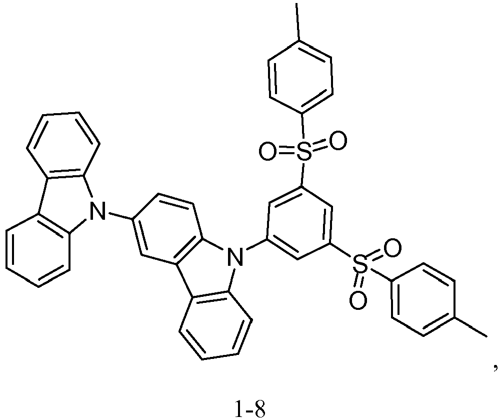

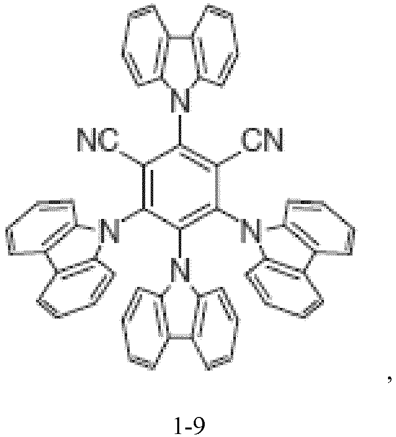

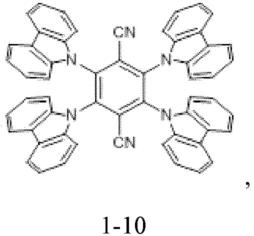

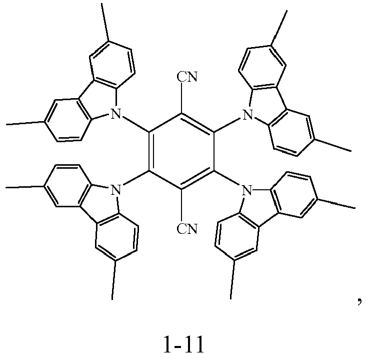

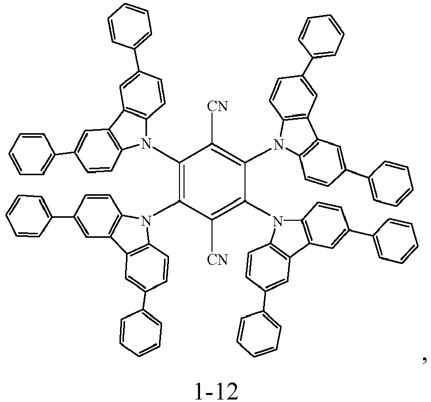

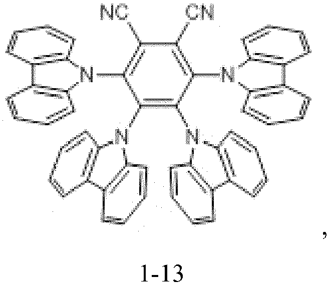

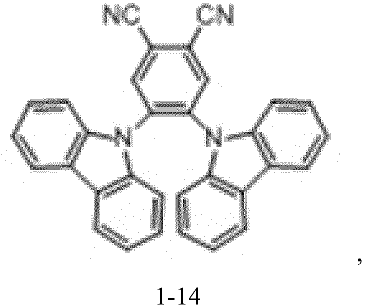

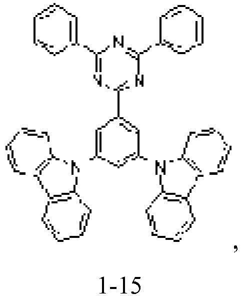

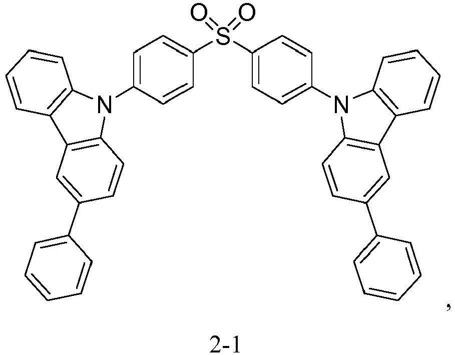

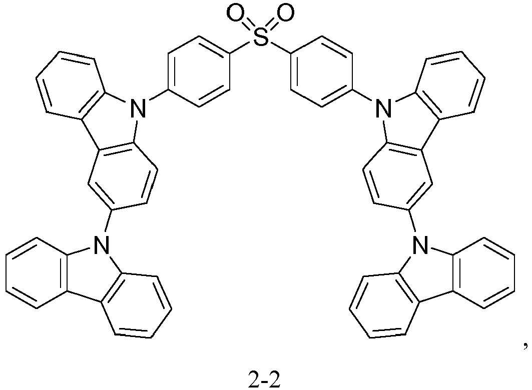

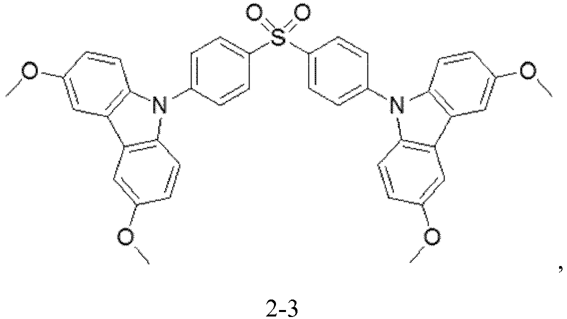

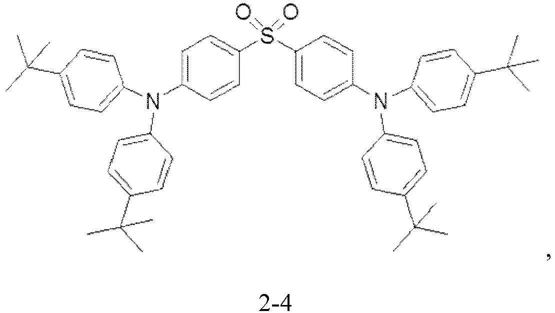

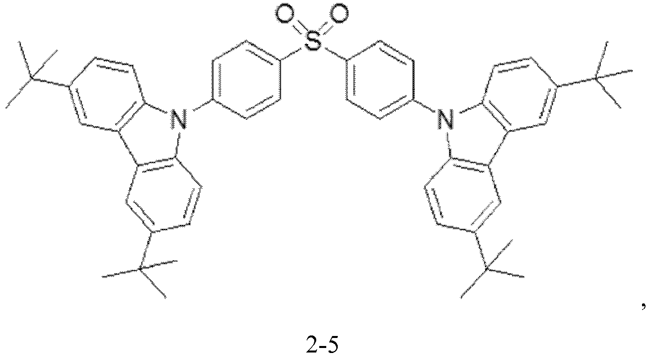

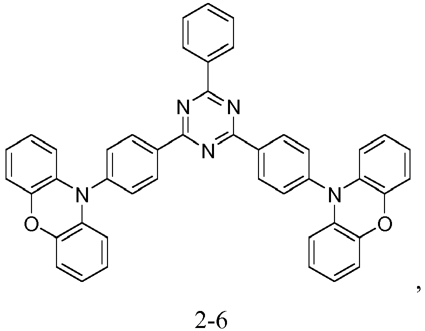

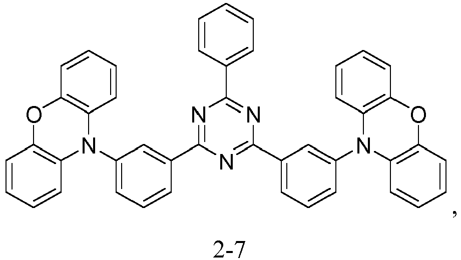

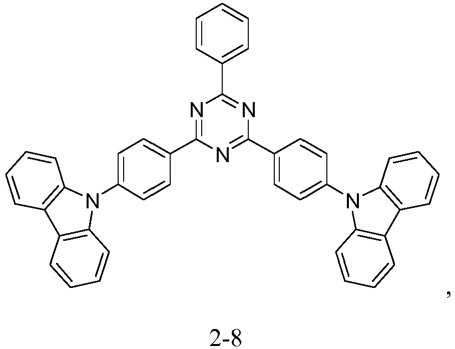

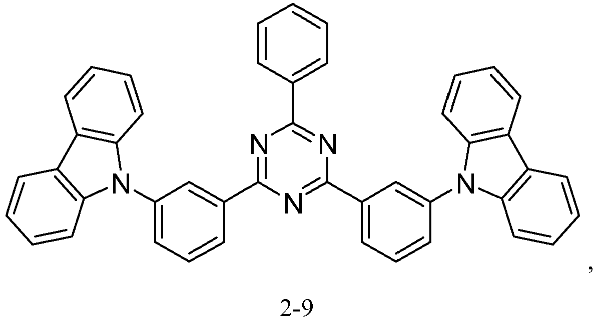

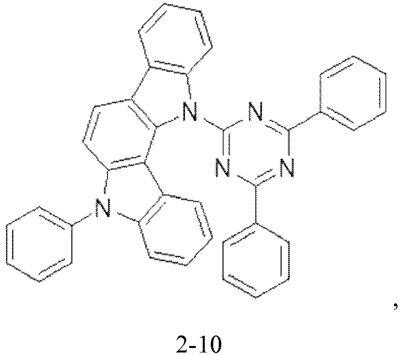

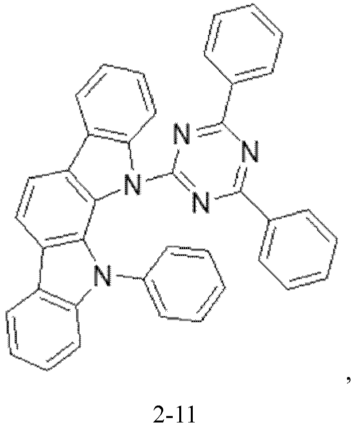

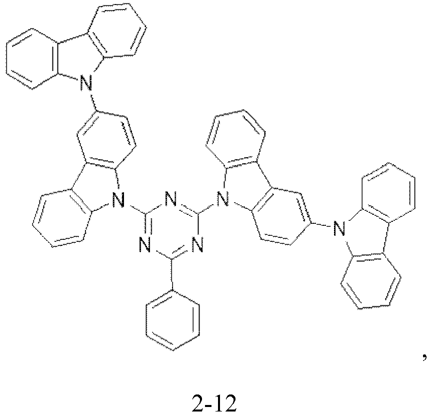

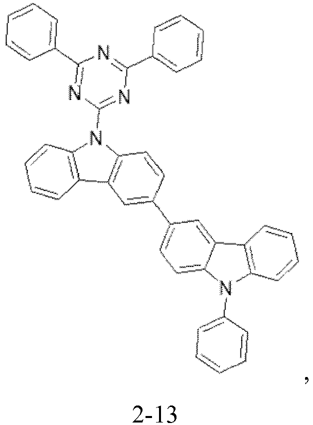

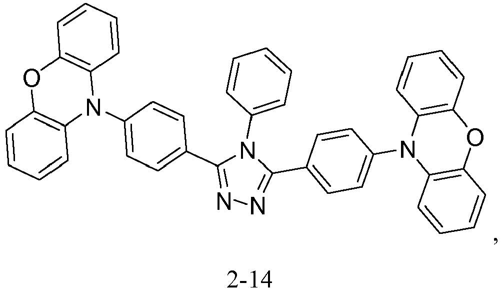

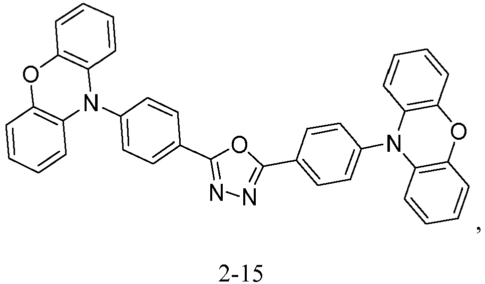

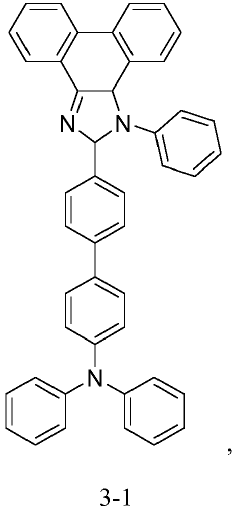

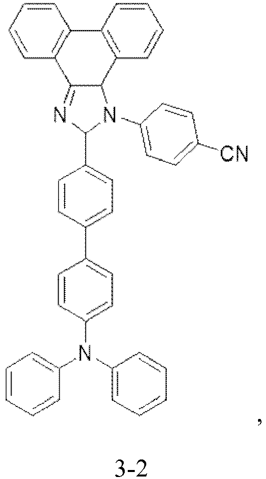

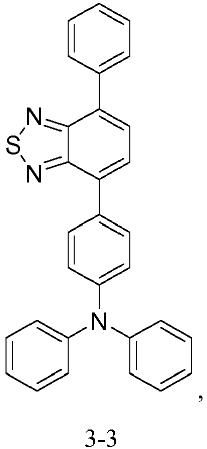

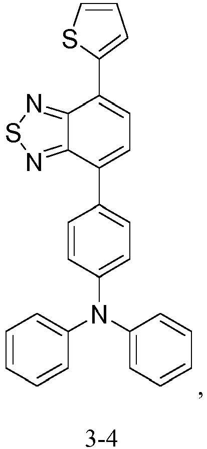

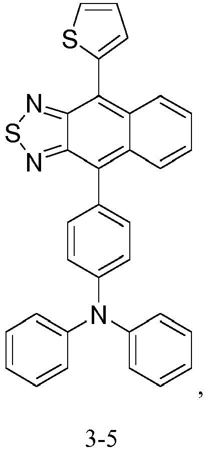

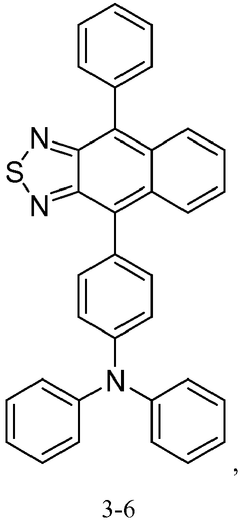

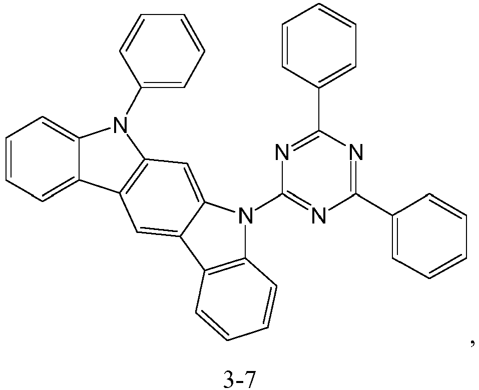

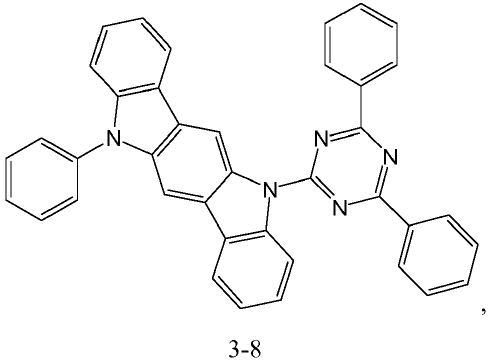

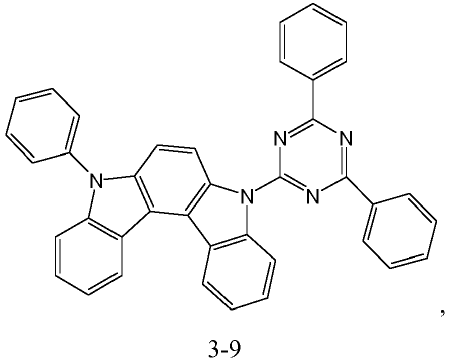

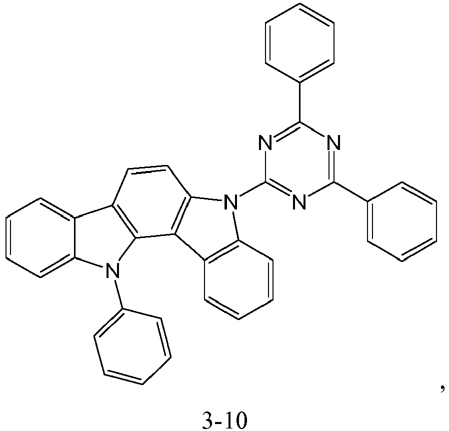

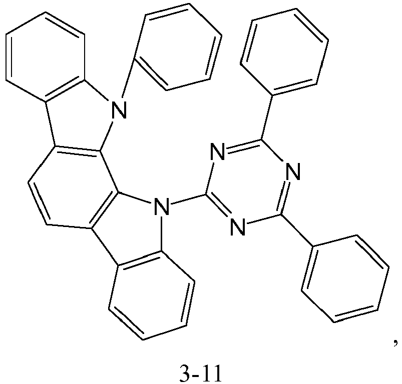

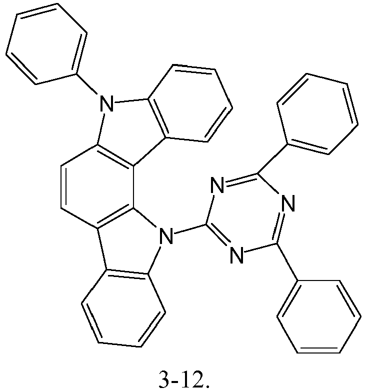

Both of the two materials that the host material consists of are thermally activated delayed fluorescence materials.

### ADVANTAGEOUS EFFECTS

The advantages of the present invention are:
In the thermally activated and sensitized phosphorescence device of the present invention, one of the host materials of the luminescent layer is a hole transport material, the other is an electron transport material, and both of the two materials are thermally activated delayed fluorescence materials. In this manner, the triplet state excitons are transferred to the singlet state, which is conducted mainly by long range Forster energy transfer, to reduce the doping proportion (<3%), save the cost, effectively suppress attenuation, and prolong the life. Additionally, the energy conversion and the luminescence are not in the same material, and thus the performance of the device is better.

### BRIEF DESCRIPTION OF THE DRAWINGS

Fig. 1 is the schematic diagram of the energy transfer of a conventional OLED luminescent layer phosphorescence system.
Fig. 2 is the schematic diagram of the structure of the organic electroluminescence device of the present invention.
Fig. 3 is the schematic diagram of the energy transfer of the OLED luminescent layer thermally activated and sensitized phosphorescence system of the present invention.
Fig. 4 is the schematic diagram of the energy transfer of the OLED luminescent layer of the present invention whose host materials are two TADF materials.
Fig. 5 is the schematic diagram of the energy transfer of the OLED luminescent layer not forming part of the present invention whose host materials are a TADF material and a regulating host material.

### EMBODIMENTS OF THE PRESENT INVENTION

The present invention will be further illustrated below by referring to the drawings and the special examples, to enable a person skilled in the art to better understand and implement the present invention, but the examples are not taken as limiting the present invention.

As shown by Fig. 2, the organic electroluminescence device of the present invention comprises an anode 02, a hole transport layer 05, a luminescent layer 06, an electron transport layer 07 and a cathode 03, which are successively deposited on a substrate 01 and are laminated.

The thermally activated and sensitized organic electroluminescence device of the present invention comprises a luminescent layer, wherein the host material of the luminescent layer is a mixture of two materials, wherein one of the two materials is a hole transport material, the other is an electron transport material, and both of the two materials are thermally activated delayed fluorescence materials; and the host material is doped by a phosphorescent dye, and the doping concentration of the phosphorescent dye in the host material is <15wt%, preferably 2wt%-10wt%, more preferably 2wt%-3wt%.

The triplet state energy level of the CT excited state of the thermally activated delayed fluorescence material is higher than the triplet state energy level of the n-π excited state by 0 to 0.3; or, the triplet state energy level of the CT excited state of the thermally activated delayed fluorescence material is higher than the triplet state energy level of the n-π excited state, wherein the difference is above 1.0eV, and, a difference between the second triplet state energy level of its n-π excited state and the first singlet state energy level of its CT excited state is-0.1 to 0.1eV.

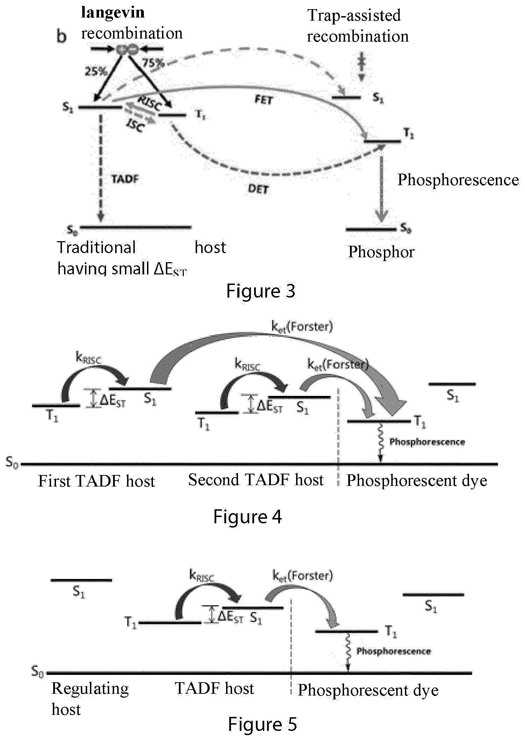

As shown by Fig. 3, in the thermally activated and sensitized phosphorescence device of the present invention, one of the host materials of the luminescent layer is a hole transport material, the other is an electron transport material, and both of the two materials are thermally activated delayed fluorescence materials. In this manner, the energy of the triplet state excitons of the host material is transferred to the singlet state by reverse intersystem crossing, and then transferred to the triplet state of the phosphorescence material by long range Forster energy transfer, which improves the energy transfer relation between the host and guest luminophor, to reduce the doping proportion (<15%), save the cost, effectively suppress attenuation, and prolong the life. Additionally, the energy conversion and the luminescence are not in the same material, and thus the performance of the device is better.

In the present invention, preferably, the thermally activated delayed fluorescence material is a material whose triplet state energy level of the CT excited state is higher than the triplet state energy level of the n-π excited state with a difference between 0-0.3eV; or, the thermally activated delayed fluorescence material is a material whose triplet state energy level of the CT excited state is higher than the triplet state energy level of the n-π excited state with a difference above 1.0eV and whose difference between the second triplet state energy level of the n-π excited state and the first singlet state energy level of the CT excited state is -0.1 to 0.1eV.

The thermally activated delayed fluorescence material of the present invention is a material whose difference between the triplet state of the CT excited state and the triplet state energy level of the n-π excited state is very small (0-0.3eV), or a material whose above difference is very large (≥1.0eV) but whose second triplet state of the n-π excited state is slightly smaller than or slightly higher than the first singlet state of the CT excited state (with a difference of (0-0.1eV). All of the materials that the present invention selects have a donor group and an acceptor group that are separated spatially, thereby resulting in the spatial separation of the HOMO and LUMO energy levels and reducing overlap integral, and thus the difference between the energy level differences between the singlet states and the triplet states of the CT states of the materials is very small. Additionally, the energy level differences between the singlet states and the triplet states of the chosen phenanthroimidazolyl, naphthathiazolyl, benzothiazolyl or anthryl are above 1.0eV, which can meet the requirements on the second material.

The thermally activated delayed fluorescence material in the present invention is a material that has charge transfer transition, and the thermally activated delayed fluorescence material has both a donor group unit and an acceptor group unit therein, wherein, the donor group unit is a donor group or a group that is formed by linking two or more donor groups; and the acceptor group unit is an acceptor group or a group that is formed by linking two or more acceptor groups. Specially, the structure of the host material may be donor-connection-acceptor, donor-acceptor-donor, and so on.

The donor group is selected from indolocarbazolyl; carbazolyl; bicarbazolyl; trianilino; phenoxazinyl; indolocarbazolyl that is substituted by one or more groups of C₁₋₆ alkyl, methoxy, ethoxy or phenyl; carbazolyl that is substituted by one or more groups of C₁₋₆ alkyl, methoxy, ethoxy or phenyl; dibenzofuranyl that is substituted by one or more groups of C₁₋₆ alkyl, methoxy, ethoxy or phenyl; trianilino that is substituted by one or more groups of C₁₋₆ alkyl, methoxy, ethoxy or phenyl; or phenoxazinyl that is substituted by one or more groups of C₁₋₆ alkyl, methoxy, ethoxy or phenyl; and
the acceptor group is selected from naphthyl; anthryl; phenanthryl; pyrenyl; triazinyl; benzimidazolyl; cyano; pyridinyl; sulfonyl; phenanthroimidazolyl; naphthathiazolyl; benzothiazolyl; oxadiazolyl; naphthyl that is substituted by one or more groups of C₁₋₆ alkyl, methoxy, ethoxy, phenyl or pyridinyl; anthryl that is substituted by one or more groups of C₁₋₆ alkyl, methoxy, ethoxy, phenyl or pyridinyl; phenanthryl that is substituted by one or more groups of C₁₋₆ alkyl, methoxy, ethoxy, phenyl or pyridinyl; pyrenyl that is substituted by one or more groups of C₁₋₆ alkyl, methoxy, ethoxy, phenyl or pyridinyl; triazinyl that is substituted by one or more groups of C₁₋₆ alkyl, methoxy, ethoxy, phenyl or pyridinyl; benzimidazolyl that is substituted by one or more groups of C₁₋₆ alkyl, methoxy, ethoxy, phenyl or pyridinyl; pyridinyl that is substituted by one or more groups of C₁₋₆ alkyl, methoxy, ethoxy, phenyl or pyridinyl; sulfonyl that is substituted by one or more groups of C₁₋₆ alkyl, methoxy, ethoxy, phenyl or pyridinyl; phenanthroimidazolyl that is substituted by one or more groups of C₁₋₆ alkyl, methoxy, ethoxy, phenyl or pyridinyl; naphthathiazolyl that is substituted by one or more groups of C₁₋₆ alkyl, methoxy, ethoxy, phenyl or pyridinyl; benzothiazolyl that is substituted by one or more groups of C₁₋₆ alkyl, methoxy, ethoxy, phenyl or pyridinyl; or oxadiazolyl that is substituted by one or more groups of C₁₋₆ alkyl, methoxy, ethoxy, phenyl or pyridinyl;
wherein, one or more of the donor group units and one or more of the acceptor group units directly link to form the thermally activated delayed fluorescence material; or, one or more of the donor group units and one or more of the acceptor group units individually link to a linking group to form the thermally activated delayed fluorescence material, wherein the linking group is a group that has a steric hindrance.

The linking group is preferably selected from spirofluorenyl; phenyl; biphenyl; spirofluorenyl that is substituted by at least one of C₁₋₆ alkyl or phenyl; phenyl that is substituted by at least one of C₁₋₆ alkyl or phenyl; or biphenyl that is substituted by at least one of C₁₋₆ alkyl or phenyl.

The donor group is preferably selected from the following structures:

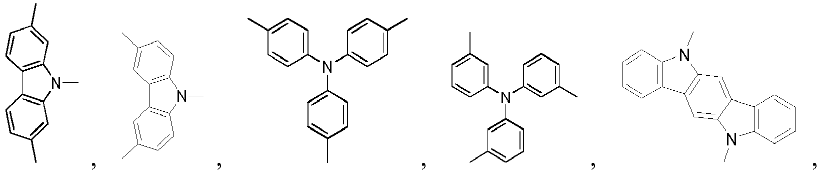

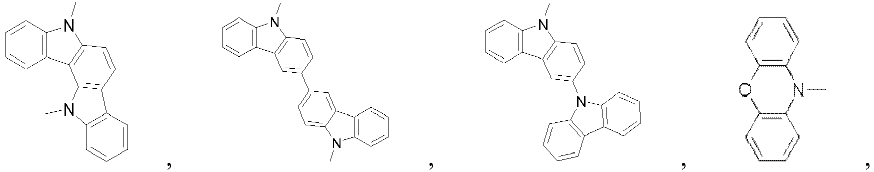

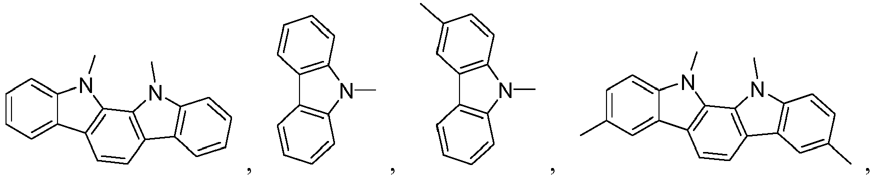

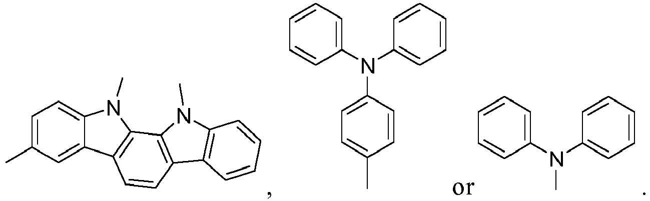

The acceptor group is preferably selected from the following structures:

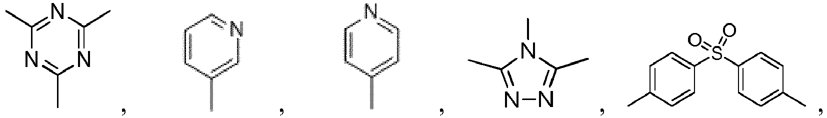

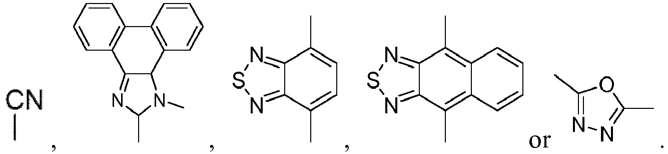

Particularly, the thermally activated delayed fluorescence material is selected from the compounds having the following structures: 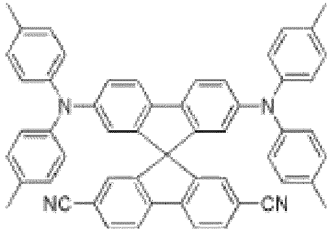
1-1 (Chem. Commun., 2012, 48, 9580-9582) 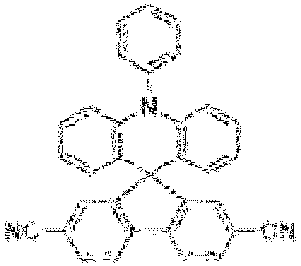
1-2 (Angew. Chem. Int. Ed., 2012, 51, 11311-11315) 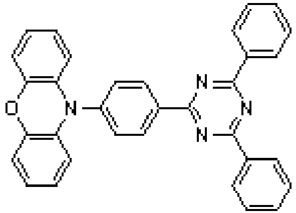
1-3 (Chem. Commun. 2012, 48, 11392-11394) 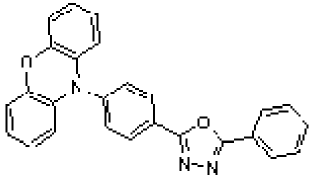
1-4 (J. Mater. Chem. C, 2013, 1, 4599-4604) 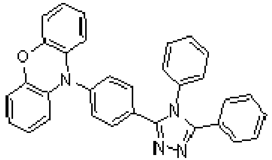
1-5 (J. Mater. Chem. C, 2013, 1, 4599-4604) 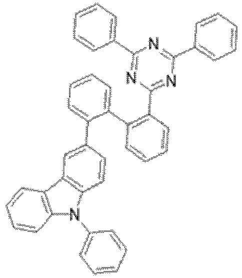
1-6 (Phys. Chem. Chem. Phys., 2013, 15, 15850) 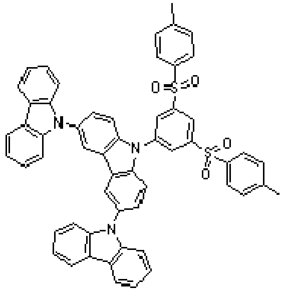
1-7 (ΔE_{ST}=0.11, calculated by using Gaussian 03/TD-DFT) 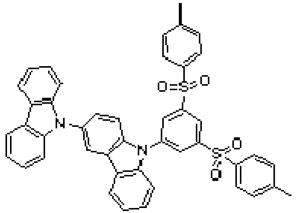
1-8 (ΔE_{ST}=0.14, calculated by using Gaussian 03/TD-DFT) 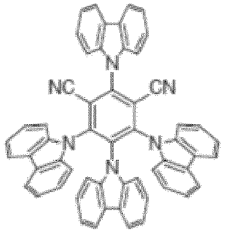
1-9 (Nature, 2012, 492, 234) 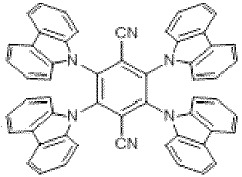
1-10 (Nature, 2012, 492, 234) 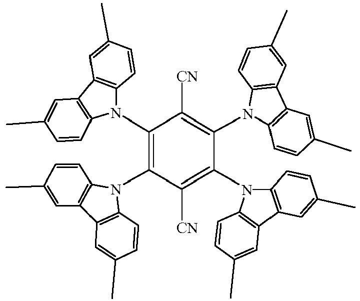
1-11 (Nature, 2012, 492, 234) 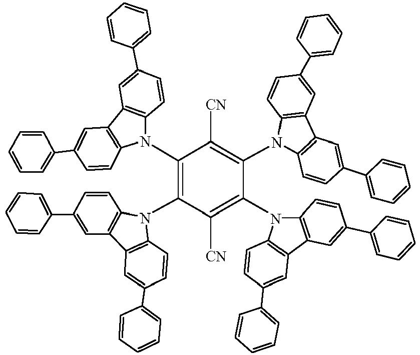
1-12 (Nature, 2012, 492, 234) 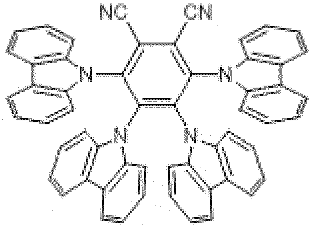
1-13 (Nature, 2012, 492, 234) 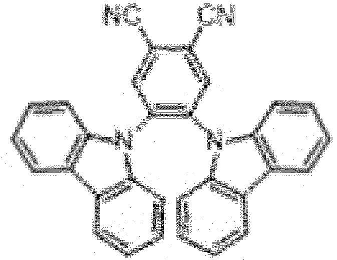
1-14 (Nature, 2012, 492, 234) 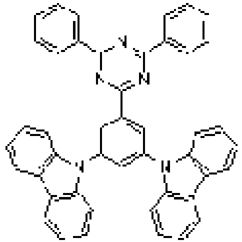
1-15 (ΔE_{ST}=0.21, calculated by using Gaussian 03/TD-DFT) 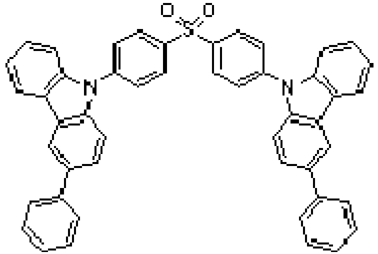
2-1 (ΔE_{ST}=0.15, calculated by using Gaussian 03/TD-DFT) 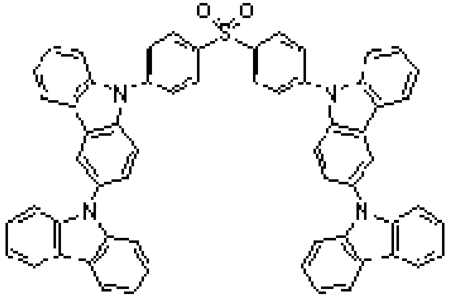
2-2 (ΔE_{ST}=0.04, calculated by using Gaussian 03/TD-DFT) 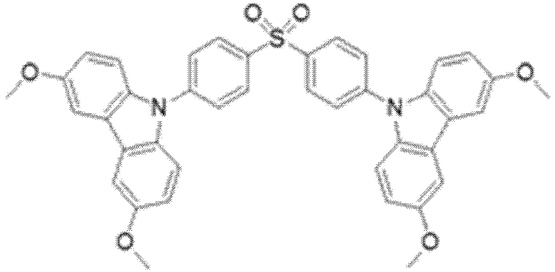
2-3 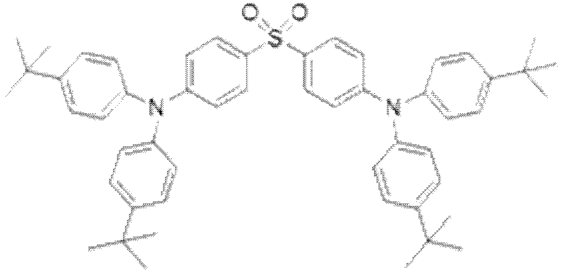
2-4 (J.AM. Chem. Soc. 2012, 134, 14706-14709) 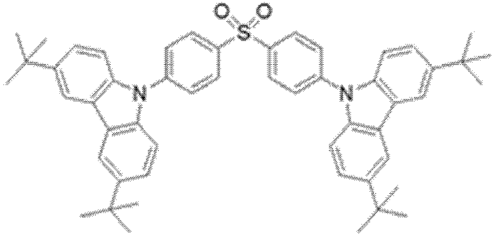
2-5 (J.AM. Chem. Soc. 2012, 134, 14706-14709) 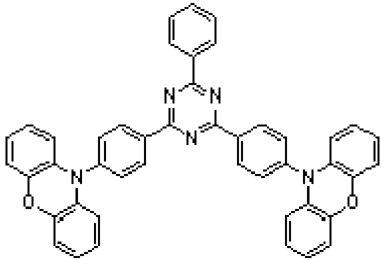
2-6 (Chem. Mater., 2013, 25 (18), pp 3766-3771) 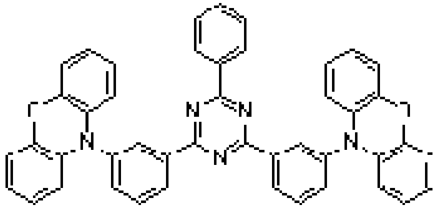
2-7 (ΔE_{ST}=0.07, calculated by using Gaussian 03/TD-DFT) 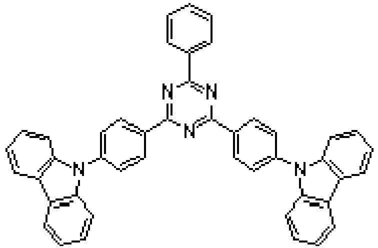
2-8 (ΔE_{ST}=0.16, calculated by using Gaussian 03/TD-DFT) 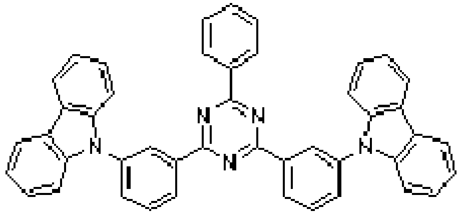
2-9 (ΔE_{ST}=0.09, calculated by using Gaussian 03/TD-DFT) 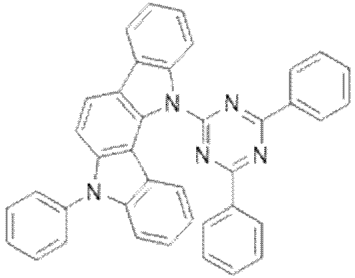
2-10 (PRL, 2013, 110, 247401) 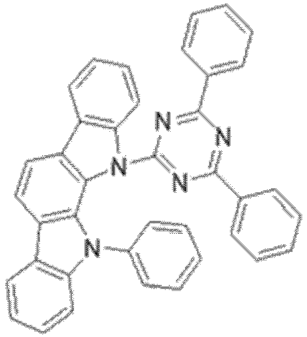
2-11 (ΔE_{ST}=0.06, calculated by using Gaussian 03/TD-DFT) 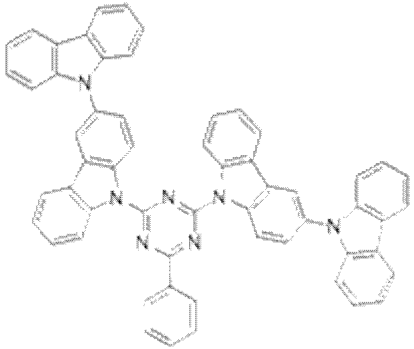
2-12 (Appl. Phys. Lett., 2012, 101, 093306) 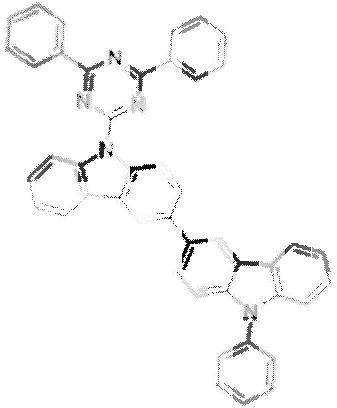
2-13(Phys. Chem. Chem. Phys. 2013, 15, 15850) 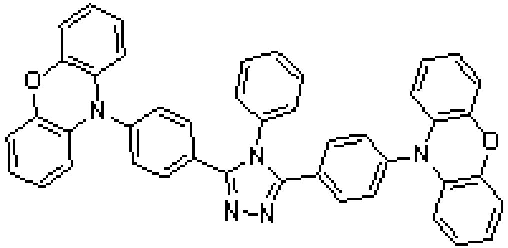
2-14 (J. Mater. Chem. C, 2013, 1, 4599-4604) 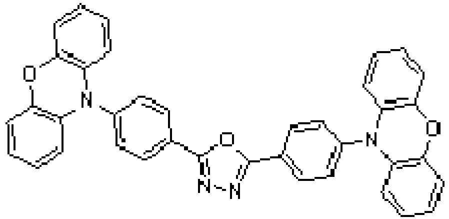
2-15 (J. Mater. Chem. C, 2013, 1, 4599-4604) 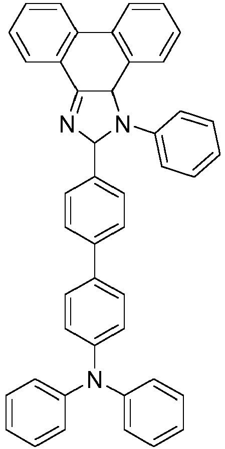
3-1 (CC, DOI: 10.1039/c3cc47130f) 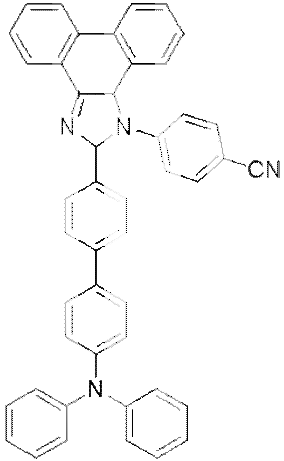
3-2 (CC, DOI: 10.1039/c3cc47130f) 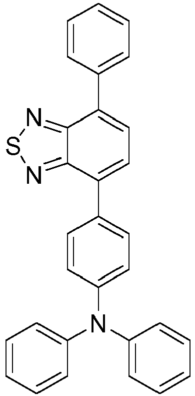
3-3 (The ΔE_{ST} of the CT state=0.03, and the energy level difference between the singlet state and the triplet state of the localized state is 1.1eV, calculated by using Gaussian 03/TD-DFT) 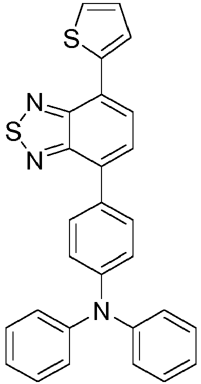
3-4 (The ΔE_{ST} of the CT state=0.05, and the energy level difference between the singlet state and the triplet state of the localized state is 1.2eV, calculated by using Gaussian 03/TD-DFT) 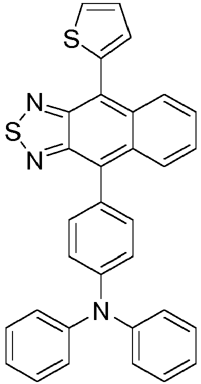
3-5 (The ΔE_{ST} of the CT state=0.01, and the energy level difference between the singlet state and the triplet state of the localized state is 1.4eV, calculated by using Gaussian 03/TD-DFT) 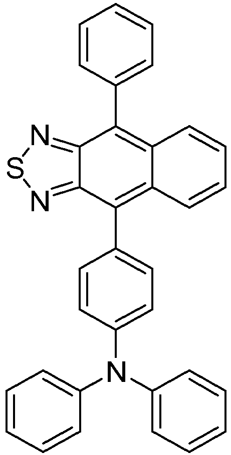
3-6 (AFM, DOI: 10.1002/adfm.201301750)

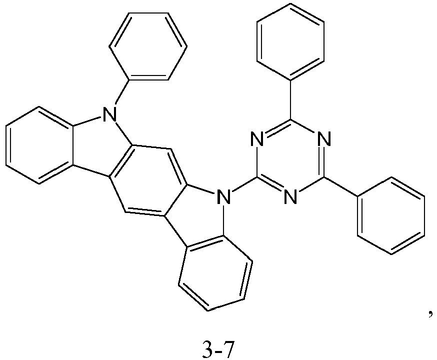

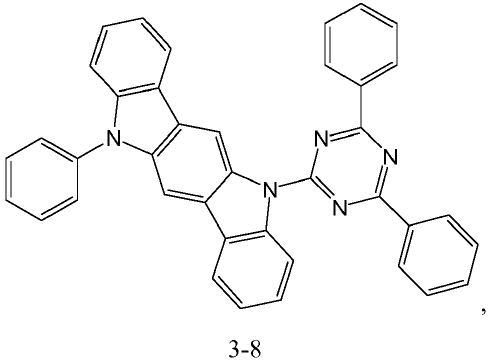

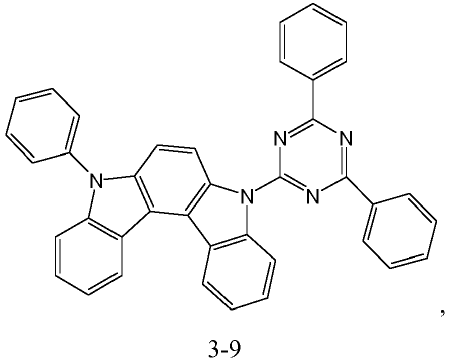

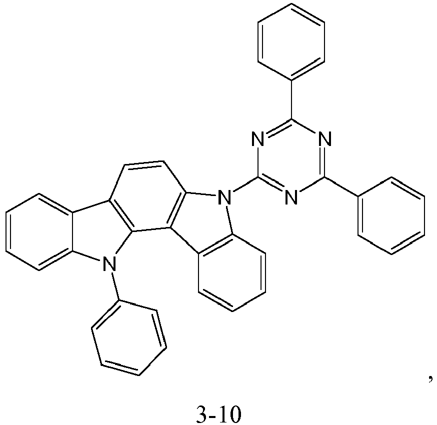

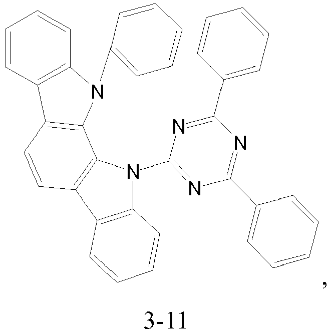

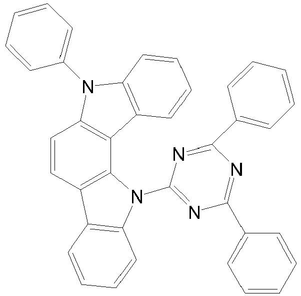

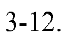

The syntheses of the relative compounds in the present application:

### 1. The synthesis of the compound 1-7

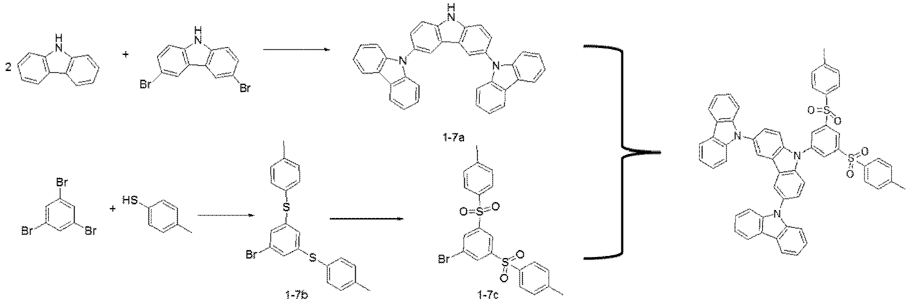

Synthesis 1-7a,
3.34g of carbazole, 3.22g of 3,6-dibromocarbazole, 0.5g of CuI, 0.5g phenanthroline and 5.2g of potassium carbonate are added into a 100ml round bottom flask, and 60ml of DMF is added. The reaction is performed under a nitrogen atmosphere by heating to reflux for 48 hours. Subsequently the reaction liquid is poured into water, and is subject to vacuum filtration under reduced pressure to obtain a solid. The solid is separated by using a chromatographic column to obtain the 1-7a, with a yield of 30%.
Mass spectrometry data: ESI-MS m/z: 498 [M⁺H]⁺, elementary analysis: C₃₆H₂₃N₃: C: 86.90, H: 4.66, N: 8.44.

Synthesis 1-7b,
3.11g of tribromobenzene, 2.48g of p-methylbenzenethiol, 6g of potassium carbonate, and 1g of copper iodide are added into a 100ml round bottom flask, and 50ml of DMF is added. The mixture is heated at 100□ under a nitrogen atmosphere for 24 hours. Subsequently the reaction liquid is poured into water, and is subject to vacuum filtration under reduced pressure to obtain a solid. The solid is separated by using a chromatographic column to obtain the 1-7b, with a yield of 60%.
Mass spectrometry data: ESI-MS m/z: 401 [M⁺H]⁺, elementary analysis: C₂₀H₁₇BrS, C: 59.85, H: 4.27.

Synthesis 1-7c,
In an ice water bath, 30ml of the 1-7b is slowly dropped into a dichloromethane solution in 1g of mCPBA, the mixture is maintained in the ice water bath till the addition ends, and subsequently the reaction is performed for 12h. The solid is separated by using a chromatographic column to obtain the 1-7c, with a yield of 99%.
Mass spectrometry data: ESI-MS m/z: 465 [M⁺H]⁺, elementary analysis: C₂₀H₁₇BrO₄S₂, C: 86.90, H: 4.66, N: 8.44.

Synthesis 1-7,
4.97g of 1-7a, 4.63g of 1-7b, 0.5g of CuI, 0.5g of phenanthroline and 5.2g of potassium carbonate are added into a 100ml round bottom flask, and 60ml of DMF is added. The reaction is performed under a nitrogen atmosphere by heating to reflux for 48 hours. Subsequently the reaction liquid is poured into water, and is subject to vacuum filtration under reduced pressure to obtain a solid. The solid is separated by using a chromatographic column to obtain the 1-7, with a yield of 60%.
Mass spectrometry data: ESI-MS m/z: 882 [M⁺H]⁺, elementary analysis: C₅₆H₃₉N₃O₄S₂, C 76.25, H 4.46, N 4.76.

### 2. The synthesis of the compound 1-4

The synthesis of the 1-4 can refer to that of the 1-7. Substance detection data: Mass spectrometry data: ESI-MS m/z: 717 [M⁺H]⁺, elementary analysis C₄₄H₃₂N₂O₄S₂, C: 73.72, H: 4.50, N: 3.91.

### 3. The synthesis of the compound 1-8

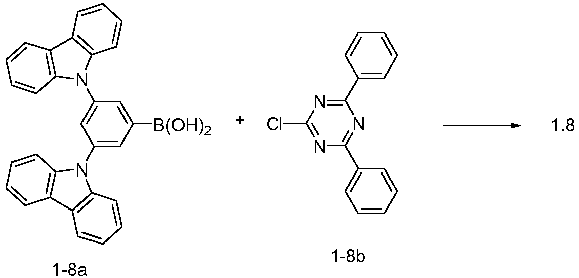

4.52g of 1-8a, 3g of 1-8b and 0.05g of tetrakis(triphenylphosphine)palladium, and 5.4g of potassium carbonate are added into a round bottom flask, and then 30ml of toluene, 20ml of water and 5ml of ethanol are added. The reaction is performed at 85□ for 48h. When the reaction ends, the mixture is extracted by using dichloromethane to obtain an organic layer, and then the organic layer is separated by using a chromatographic column to obtain the 1-8, with a yield of 65%.
Mass spectrometry data: ESI-MS m/z: 640 [M⁺H]⁺, elementary analysis: C₄₅H₂₉N₅, C: 84.48, H: 4.57, N: 10.95.

### 4. The synthesis of the compound 2-1

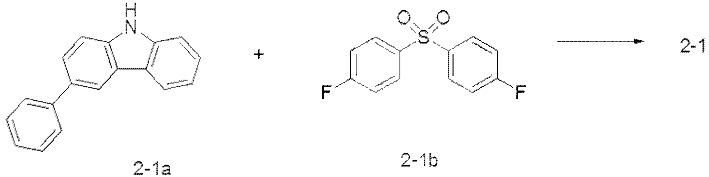

2.43g of 2-1a is added into an ultra-dry solution (30ml) of 0.24g of NaH, and is stirred at room temperature for 30 min. Then a DMF solution of 2.54g of 2-1b is dropped into the above solution, heated to 100□, and stirred for 1 hour. After being cooled, the mixture is poured into water, and the solid is filtered, and separated by using a chromatographic column, to obtain 2-1.
Mass spectrometry data: ESI-MS m/z: 701 [M⁺H]⁺, elementary analysis: C₄₈H₃₂N₂O₂S, C: 82.26, H: 4.60, N: 4.0.

### 5. The synthesis of the compound 2-2

The synthesis of the compound 2-2 can refer to that of 2-1, wherein the method is basically the same as that of the compound 2-1, and the difference is that the 2-1a is replaced by bicarbazole.
Mass spectrometry data: ESI-MS m/z: 879 [M⁺H]⁺, elementary analysis: C₆₀H₃₈N₄O₂S, C: 81.98, H: 4.36, N: 6.37.

### 6. The synthesis of the compound 2-7

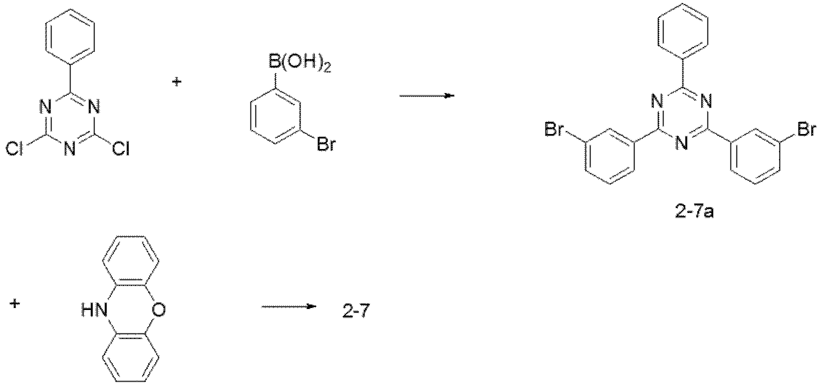

Synthesis 2-7a,
2.25g of 2,4-dichloro-6-phenyl triazine, 2g of m-bromophenylboronic acid, 0.05g of tetrakis(triphenylphosphine)palladium, and 5.4g of potassium carbonate are added into a round bottom flask, and then 30ml of toluene, 20ml of water and 5ml of ethanol are added. The reaction is performed at 85□ for 48h. When the reaction ends, the mixture is extracted by using dichloromethane to obtain an organic layer, and then the organic layer is separated by using a chromatographic column to obtain the 2-7a, with a yield of 58%.
Mass spectrometry data: ESI-MS m/z: 466 [M⁺H]⁺, elementary analysis: C₂₁H₁₃Br₂N₃, C: 53.99, H: 2.80, N: 8.99.

Synthesis 2-7,
4.65g of 2-7a, 3.66g of phenoxazine, 0.5g of CuI, 0.5g of phenanthroline and 5.2g of potassium carbonate are added into a 100ml round bottom flask, and 60ml of DMF is added. The reaction is performed under a nitrogen atmosphere by heating to reflux for 48 hours. Subsequently the reaction liquid is poured into water, and is subject to vacuum filtration under reduced pressure to obtain a solid, The solid is separated by using a chromatographic column to obtain the 2-7, with a yield of 48%.
Mass spectrometry data: ESI-MS m/z: 672 [M⁺H]⁺, elementary analysis: C₄₅H₂₉N₅O₂, C: 80.46, H: 4.35, N: 4.76.

### 7. The synthesis of the compound 2-8

Synthesis 2-8a,
2.25g of 2,4-dichloro-6-phenyl triazine, 2g of p-bromophenylboronic acid, 0.05g of tetrakis(triphenylphosphine)palladium, and 5.4g of potassium carbonate are added into a round bottom flask, and then 30ml of toluene, 20ml of water and 5ml of ethanol are added. The reaction is performed at 85°C for 48h. When the reaction ends, the mixture is extracted by using dichloromethane to obtain an organic layer, and then the organic layer is separated by using a chromatographic column to obtain the 2-8a, with a yield of 55%.
Mass spectrometry data: ESI-MS m/z: 466 [M⁺H]⁺, elementary analysis: C₂₁H₁₃Br₂N₃, C: 53.99, H: 2.80, N: 8.99.

Synthesis 2-8,
4.65g of 2-8a, 3.66g of phenoxazine, 0.5g of CuI, 0.5g of phenanthroline and 5.2g of potassium carbonate are added into a 100ml round bottom flask, and 60ml of DMF is added. The reaction is performed under a nitrogen atmosphere by heating to reflux for 48 hours. Subsequently the reaction liquid is poured into water, and is subject to vacuum filtration under reduced pressure to obtain a solid, The solid is separated by using a chromatographic column to obtain the 2-8, with a yield of 56%.
Mass spectrometry data: ESI-MS m/z: 640 [M⁺H]⁺, elementary analysis: C₄₅H₂₉N₅, C: 84.48, H: 4.57, N: 10.95.

### 8. The synthesis of the compound 2-9

The synthesis of the 2-9 can refer to that of 2-7, wherein the difference is using a different donor group, by replacing phenoxazine with carbazole. 4.65g of 2-8a, 3.0g of carbazole, 0.5g of CuI, 0.5g of phenanthroline and 5.2g of potassium carbonate are added into a 100ml round bottom flask, and 60ml of DMF is added. The reaction is performed under a nitrogen atmosphere by heating to reflux for 48 hours. Subsequently the reaction liquid is poured into water, and is subject to vacuum filtration under reduced pressure to obtain a solid, The solid is separated by using a chromatographic column to obtain the 2-9, with a yield of 50%.
Mass spectrometry data: ESI-MS m/z: 640 [M⁺H]⁺, elementary analysis: C₄₅H₂₉N₅, C: 84.48, H: 4.57, N: 10.95.

### 9. The synthesis of the compound 2-11

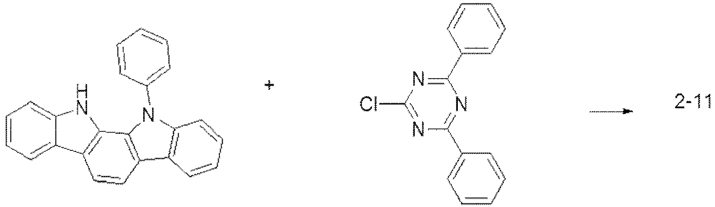

Synthesis 2-11,
3.32g of phenylindolocarbazole, 2.67g 2-chloro-4,6-diphenyl triazine, 0.5g of CuI, 0.5g of phenanthroline and 5.2g of potassium carbonate are added into a 100ml round bottom flask, and 60ml of DMF is added. The reaction is performed under a nitrogen atmosphere by heating to reflux for 48 hours. Subsequently the reaction liquid is poured into water, and is subject to vacuum filtration under reduced pressure to obtain a solid. The solid is separated by using a chromatographic column to obtain the 2-7, with a yield of 48%.
Mass spectrometry data: ESI-MS m/z: 564 [M⁺H]⁺, elementary analysis: C₃₉H₂₅N₅, C: 83.10, H: 4.47, N: 12.43.

### 10. The synthesis of the compound 3-3

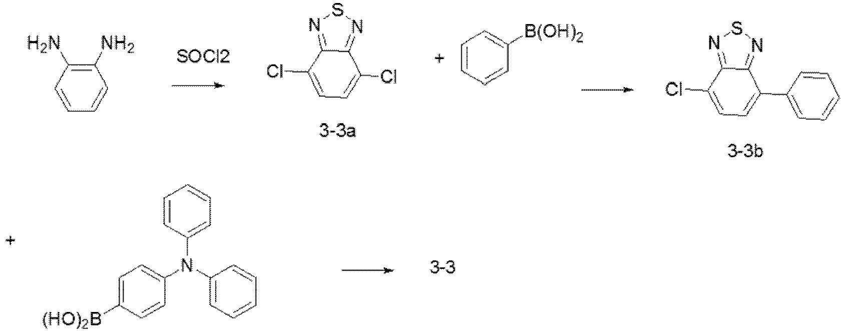

Synthesis 3-3a,
3ml of pyridine is added into a mixed solution of o-phenylene diamine (0.6 g) and thionyl chloride (5ml), stirred at 60□ for 10 hours, extracted by using dichloromethane, and then washed by using a large amount of water to obtain a solid.
Mass spectrometry data: ESI-MS m/z: 205.

Synthesis 3-3b,
2.25g of 3-3a, 2g of phenylboronic acid, 0.05g of tetrakis(triphenylphosphine)palladium, and 5.4g of potassium carbonate are added into a round bottom flask, and then 30ml of toluene, 20ml of water and 5ml of ethanol are added. The reaction is performed at 85°C for 48h. When the reaction ends, the mixture is extracted by using dichloromethane to obtain an organic layer, and then the organic layer is separated by using a chromatographic column to obtain the 3-3a, with a yield of 58%.
Mass spectrometry data: ESI-MS m/z: 246 [M⁺H]⁺.

Synthesis 3-3,
2.46g of 3-3b, 2.39g of 4-boric acid triphenylamine, 0.05g of tetrakis(triphenylphosphine)palladium, and 5.4g of potassium carbonate are added into a round bottom flask, and then 30ml of toluene, 20ml of water and 5ml of ethanol are added. The reaction is performed at 85°C for 48h, When the reaction ends, the mixture is extracted by using dichloromethane to obtain an organic layer, and then the organic layer is separated by using a chromatographic column to obtain the 3-3, with a yield of 58%.
Mass spectrometry data: ESI-MS m/z: 456 [M⁺H]⁺, elementary analysis: C₃₀H₂₁N₃S, C: 79.09, H: 4.65, N: 9.22.

### 11. The synthesis of the compound 3-4

The synthesis of the compound 3-4 can refer to the compound 3-3, wherein the steps are basically the same, and the difference is that the acceptor group is benzothiazole substituted by thiophene.
Mass spectrometry data: ESI-MS m/z: 462 [M⁺H]⁺, elementary analysis: C₂₈H₁₉N₃S₂: C: 72.86, H: 4.15, N: 9.10.

### 12. The synthesis of the compound 3-5

The synthesis of the compound 3-5 can refer to the compound 3-3, wherein the steps are basically the same, and the difference is that the acceptor group is naphthathiazole substituted by thiophene.
Mass spectrometry data: ESI-MS m/z: 512 [M⁺H]⁺, elementary analysis: C₃₂H₂₁N₃S₂: C: 75.12, H: 4.15, N: 8.21.

The two materials that the host material consists of of the present invention are thermally activated delayed fluorescence materials, and the energy transfer process is as shown by Fig. 4: the first TADF host and the second TADF host individually transfer the triplet state energy to the singlet state by reverse intersystem crossing, and then transfer all of the energy to the triplet state of the phosphorescent dye by Forster, thereby reducing the distance between the host and the guest, to utilize the energy of the host with a high efficiency and reduce the consumption of the phosphorescence materials, and effectively solving the problem of roll-off, to improve the stability of the device.

In the examples not forming part of the present invention one of the two materials is a thermally activated delayed fluorescence material (the TADF host), and the other is a regulating host material (regulating host). One of them is an electron transport material, and the other is a hole transport material. The energy transfer principle is as shown by Fig. 5: the common triplet state energy of the TADF host and the regulating host is transferred to the singlet state by reverse intersystem crossing, and then transfer all of the energy to the triplet state of the phosphorescent dye by Forster, thereby reducing the distance between the host and the guest, to utilize the energy of the host with a high efficiency and reduce the consumption of the phosphorescence materials, and effectively solving the problem of roll-off, to improve the stability of the device.

The embodiments of the organic luminescence display device of the present invention: The anode may employ an inorganic material or an organic conductive polymer. The inorganic material may generally employ metal oxides such as indium tin oxide (ITO), zinc oxide (ZnO), and indium zinc oxide (IZO) or metals of high work functions such as gold, copper and silver, preferably ITO. The organic conductive polymer is preferably one of polythiophene/polyvinyl sodium benzenesulfonate (hereafter referred to as simply PEDOT/PSS) and polyaniline (hereafter referred to as simply PANI).

The cathode generally employs metals of low work function such as lithium, magnesium, calcium, strontium, aluminum and indium or their alloys with copper, gold or silver, or an electrode layer that is formed by the alternating of a metal and a metal fluoride. In the present invention the cathode is preferably laminated LiF layer and Al layer (the LiF layer is on the outer side).

The material of the hole transport layer may be selected from lower molecular weight materials of the arylamine type and the branched polymer type, preferably NPB.

The material of the electron transport layer may employ an organic metal complex (such as Alq₃, Gaq₃, BAlq or Ga (Saph-q)) or other materials that are commonly used for electron transport layer, such as aromatic condensed ring type (such as pentacene and perylene) or o-phenanthroline type (such as Bphen and BCP) compounds.

The organic electroluminescence device of the present invention may also be provided with a hole injection layer 04 (which may be omitted) between the anode and the hole transport layer. The material of the hole injection layer may employ, for example, 4,4',4"-tris(3-methylphenylaniline)triphenylamine) doped F4TCNQ or copper phthalocyanine (CuPc), or may be a metal oxide, such as molybdenum oxide and rhenium oxide.

The thicknesses of the layers may employ the conventional thicknesses of the layers in the art.

The present invention further provides the preparation method of the organic electroluminescence device, which comprises successively depositing on the substrate 01 the anode 02, the hole transport layer 05, the luminescent layer 06, the electron transport layer 07 and the cathode 03, which are laminated, and packaging.

The substrate may be glass or a flexible base sheet. The flexible base sheet may employ a polyester type or polyimide type compound material or a thin sheet metal. The laminating and the packaging may employ any suitable method that is known by a person skilled in the art.

For convenience, the abbreviations and full names of some organic materials that are involved in the description are listed as follows:

| Abbreviation | Full name | Structural formula |
|---|---|---|
| Alq₃ | tris(8-hydroxylquinoline)aluminum | 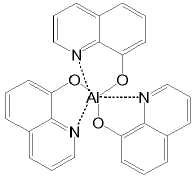 |
| BAlq | di(2-methyl-8-quinolinyl)-4-phenylphenolaluminum (III) | 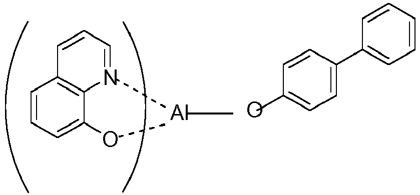 |
| BCP | 2,9-dimethyl-4,7-diphenyl-1,10-o-phenanthroline | 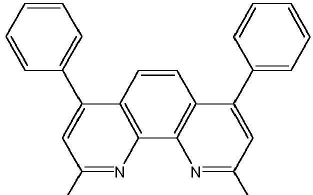 |
| Bphen | 4,7-diphenyl-1,10-o-phenanthroline | 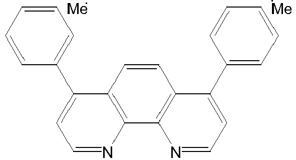 |
| C545T | 10-(2-benzothiazole)-1,1,7 ,7,-tetramethyl-2,3,6,7-tetrahydro-1H,5H,11H-benzo[1]pyran[6,7,8-ij]qumolizine | 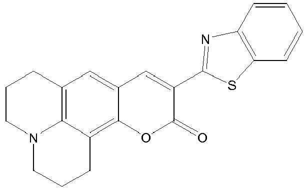 |
| CBP | 4,4'-N,N'-dicarbazole-biphenyl | 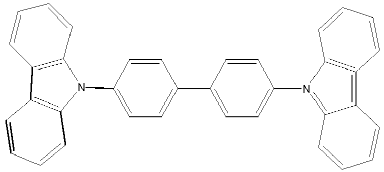 |
| CPF | 9,9-di(4-dicarbazole-phenyl)fluorine | 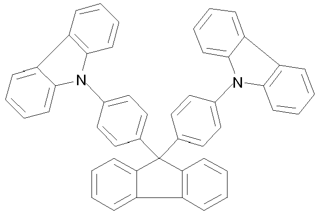 |
| m-MTDATA | 4,4',4"-tris(3-methylphenylaniline)triphenylamine | 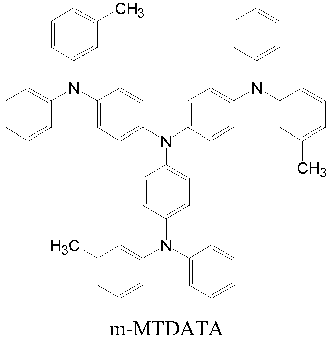 |
| NPB | N,N'-di-(1-naphthyl)-N,N'-diphenyl-1,1'-biphenyl-4, 4'-diamine | 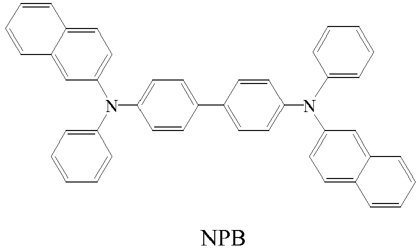 |
| PBD | 2-(4-tertbutylphenyl)-5-(4-biphenyl)-1,3,4-oxadiazol | 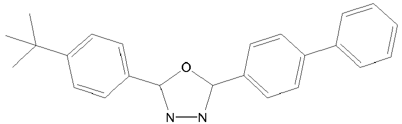 |
| Pentacene | pentacene | 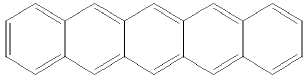 |
| TPD | N,N'-diphenyl-N,N'-bis(m-methylphenyl)-1,1'-biphenyl-4,4'-diamine | 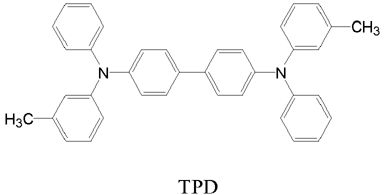 |
| perylene | perylene | 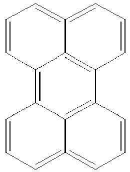 |
| DCJTB | 4-4-dicyanomethylene-2-tertbutyl-6-(1,1,7,7-tetramethyl-julolidine-9-ethenyl)-4H-pyran | 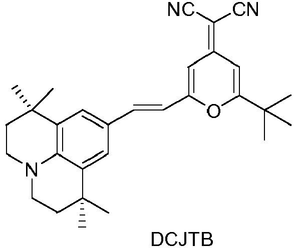 |
| DCM | 4-dicyanomethylene-2-methyl-6-(p-dimethylaminostyrenyl)-4H-pyran | 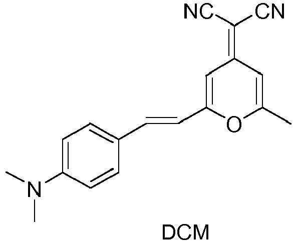 |
| Rubrene | 5,6,11,12-tetraphenyltetracene | 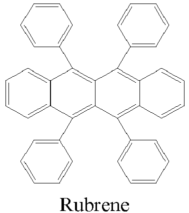 |
| DCM-1 | 4-(dimercaptomethylene)-2-methyl-6-(p-dimethylaminostyrenyl)-4H-pyrane | 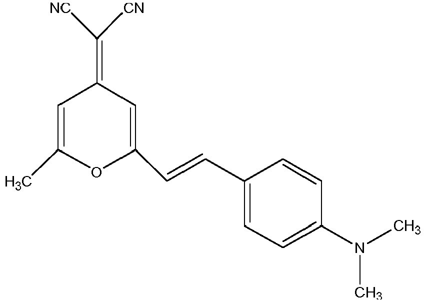 |
| DMQA | N,N'-dimethylquinacridone | 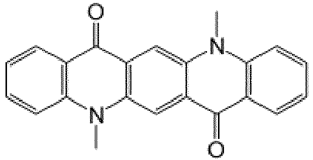 |
| F4TCNQ | 2,3,5,6-tetrafluoro-7,7',8,8 '-tetracyanodimethyl-p-benzoquinone | 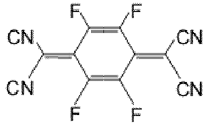 |
| niBr | N-2,6-dibromophenyl-1,8-naphthalimide | 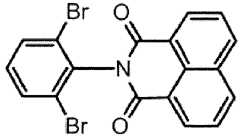 |
| TCTA | 4,4',4"-tris(carbazol-9-yl)trianiline | 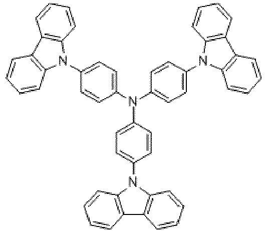 |
| mCP | 1,3-dicarbazol-9-ylbenzene | 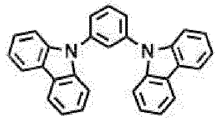 |
| Ir(ppy)3 | tris(2-phenylpyridine)iridium(III) | 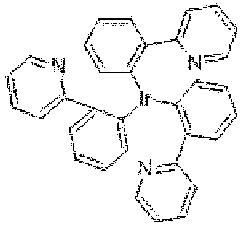 |
| Ir(piq)3 | tris(1-phenyl-isoquinoline)iridium(III) | 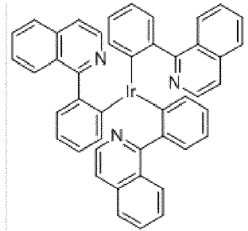 |

The present invention is further illustrated below by the Examples.

### Example 1

In this Example luminescence devices that have different doping concentrations of thermally activated delayed fluorescence materials are prepared, and those devices have the structure as shown by Fig. 3. The host materials of the luminescent layers (thermally activated delayed fluorescence materials Host1 (1-9), thermally activated delayed fluorescence materials Host2 (2-4), the phosphorescent dye doping the host materials (Ir(ppy)₃). The thermally activated delayed fluorescence materials Host2 (2-4) are electron transport materials, and the thermally activated delayed fluorescence materials Host1 (1-9) are hole transport materials):
The structure of the device of this Example is as follows:
ITO (150nm)/NPB (40nm)/host material: (2%, 3%, 10%, 14%) phosphorescent dye (30nm)/Alq₃ (20nm)/LiF (0.5nm)/Al (150nm)

In that, the percentages in the parentheses preceding the phosphorescent dye indicate different doping concentrations, and in this Example and below, the doping concentrations are all in wt%.

The particular preparation method of the organic electroluminescence device is as follows:
Firstly, washing a glass substrate by using a detergent and deionized water, drying it in an infrared lamp, and sputtering a layer of anode material on the glass, with the film thickness of 150nm;
then, placing the glass substrate having an anode into a vacuum cavity, vacuumizing to 1×10⁻⁴ Pa, and continually coating by vaporization NPB on the anode layer film as the hole transport layer, with the film forming speed of 0.1nm/s and the vaporization coating film thickness of 40nm;
coating by vaporization the luminescent layer on the hole transport layer, by the approach of double source co-vaporization, by adjusting the film forming speed by using a film thickness monitor according to the mass percentage between the host material and the phosphorescent dye, with the vaporization coating film thickness of 30nm;
continually coating by vaporization a layer of Alq₃ material on the luminescent layer as the electron transport layer, with the vaporization coating speed of 0.1nm/s and the total vaporization coating film thickness of 20nm; and
finally coating by vaporization successively a LiF layer and an Al layer on the luminescent layer as the cathode layer of the device, wherein the vaporization coating speed of the LiF layer is 0.01-0.02nm/s and the thickness is 0.5nm, and the vaporization coating speed of the Al layer is 1.0nm/s and the thickness is 150nm.

### Comparative Example 1

An organic electroluminescence device is prepared by using the method the same as that of Example 1, and the structure of the device is as follows:
ITO (150nm)/NPB (40nm)/host material: (15%) phosphorescent dye (30nm)/Alq₃ (20nm)/LiF (0.5nm)/Al (150nm)
The host material of the luminescent layer is CBP:BAlq, and the phosphorescent dye is the same as that of Example 1.

### Comparative Example 2

An organic electroluminescence device is prepared by using the method the same as that of Example 1, and the structure of the device is as follows:
ITO (150nm)/NPB (40nm)/host material: (15%, 20%) phosphorescent dye (30nm)/Alq₃ (20nm)/LiF (0.5nm)/Al (150nm)
The host materials of the luminescent layers (thermally activated delayed fluorescence materials Host1 (1-9), thermally activated delayed fluorescence materials Host2 (2-4)), and the phosphorescent dye is the same as that of Example 1.

The performances of the organic electroluminescence devices of Example 1 and Comparative Example 1 are presented in Table 1, and the percentages of the luminescent layer compositions in the table indicate the mass percentages of the components in the luminescent layers:

**Table 1**

| Device | Luminescent Layer Composition | Luminescence Efficiency (cd/A) | Luminance (cd/m²) | External Quantum Efficiency (%) | Life T90 (hrs) |
|---|---|---|---|---|---|
| Example 1 | host material (thermally activated delayed fluorescence material Host 1 (1-9) (39wt%), thermally activated delayed fluorescence material Host 2 (2-4) (59wt%):phosphorescent dye (2wt%) | 44.5 | 5000 | 12.5 | 390 |
| | host material (thermally activated delayed fluorescence material Host 1 (1-9) (38wt%), thermally activated delayed fluorescence material Host 2 (2-4) (59wt%):phosphorescent dye (3wt%) | 46.0 | 5000 | 13.3 | 421 |
| | host material (thermally activated delayed fluorescence material Host 1 (1-9) (36%), thermally activated delayed fluorescence material Host 2 (2-4) (54%):phosphorescent dye (10 %) | 38.4 | 5000 | 11.4 | 378 |
| | host material (thermally activated delayed fluorescence material Host 1 (1-9) (34%), thermally activated delayed fluorescence material Host 2 (2-4) (52%)):phosphorescent dye (14 %) | 35.1 | 5000 | 10.1 | 370 |
| Comparative Example 1 | host material (CBP (34%):BAlq (51%)):phosphorescent dye (15 %) | 28.0 | 5000 | 8.0 | 289 |
| Comparative Example 2 | host material (thermally activated delayed fluorescence material Host 1 (1-9) (34%), thermally activated delayed fluorescence material Host 2 (2-4) (51%):phosphorescent dye (15 %) | 32.7 | 5000 | 9.7 | 345 |
| | host material (thermally activated delayed fluorescence material Host 1 (1-9) (32%), thermally activated delayed fluorescence material Host 2 (2-4) (48%):phosphorescent dye (20 %) | 29 | 5000 | 6.4 | 296 |

It can be seen from Table 1 that, when the host material employs the mixture of an electron transport material and a hole transport material, and they both employ a TADF material, the luminescence efficiencies of the double thermally activated delayed fluorescence host materials are obviously increased compared with the efficiency of the single host material, and the lives are also obviously increased compared with the lives of the traditional double host devices.

In addition, when the doping concentrations of the phosphorescent dyes are less than 15%, their luminescence efficiencies are all higher than the efficiencies when the doping concentrations are > 15%, the lives are also increased, and the big amount of the consumption of the expensive phosphorescent dye is eliminated.

### Example 2 (not forming part of the present invention)

In this Example luminescence devices that have different doping concentrations of thermally activated delayed fluorescence materials are prepared, and those devices have the structure as shown by Fig. 3. The host materials of the luminescent layers (thermally activated delayed fluorescence materials Host 3 (1-10), regulating host material (CBP), the phosphorescent dye doping the host materials Ir(piq)₃. The thermally activated delayed fluorescence materials Host 3 (1-10) are electron transport materials, and the regulating host material CBP is a hole transport material, wherein their triplet state energy levels are the same): the structure of the device of this Example is as follows:
ITO (150nm)/NPB (40nm)/host material: (2%, 3%, 10%, 14%) phosphorescent dye (30nm)/Alq₃ (20nm)/LiF (0.5nm)/Al (150nm)
In that, the percentages in the parentheses preceding the phosphorescent dye indicate different doping concentrations, and in this Example and below, the doping concentrations are all in wt%.

### Comparative Example 3

An organic electroluminescence device is prepared by using the method the same as that of Example 1, and the structure of the device is as follows:
ITO (150nm)/NPB (40nm)/host material: (15%, 20%) phosphorescent dye (30nm)/Alq₃ (20nm)/LiF (0.5nm)/Al (150nm)
The host materials of the luminescent layers (thermally activated delayed fluorescence materials Host 3 (1-10)), regulating host material CBP, and the phosphorescent dye is the same as that of Example 2.

The performances of the organic electroluminescence devices of Example 2 and Comparative Example 3 are as shown by Table 2:

**Table 2**

| Device | Luminescent Layer Composition | Luminescence Efficiency (cd/A) | Luminance (cd/m²) | External Quantum Efficiency (%) | Life T90 (hrs) |
|---|---|---|---|---|---|
| Example 2 | host material (thermally activated delayed fluorescence material Host 3 (1-10)(59%), regulating host material CBP (39%):phosphorescent dye (2%) | 48.6 | 5000 | 18.0 | 457 |
| | host material (thermally activated delayed fluorescence material Host 3 (1-10)(59%), regulating host material CBP (38%):phosphorescent dye (3%) | 53.5 | 5000 | 19.3 | 490 |
| | host material (thermally activated delayed fluorescence material Host 3 (1-10)(54%), regulating host material CBP (36%):phosphorescent dye (10%) | 45.1 | 5000 | 17.4 | 423 |
| | host material (thermally activated delayed fluorescence material Host 3 (1-10)(52%), regulating host material CBP (34%):phosphorescent dye (14%) | 42.5 | 5000 | 16.9 | 410 |
| Comparative Example 3 | host material (thermally activated delayed fluorescence material Host 3 (1-10) (51%), regulating host material CBP (34%):phosphorescent dye (15%) | 41.7 | 5000 | 16.8 | 407 |
| | host material (thermally activated delayed fluorescence material Host 3 (1-10) (48%), regulating host material CBP (32%):phosphorescent dye (20%) | 39.2 | 5000 | 13.5 | 389 |

It can be seen from Table 2 that, when the doping concentrations of the phosphorescent dyes are less than 15%, their luminescence efficiencies are all higher than the efficiencies when the doping concentrations are >15%, the lives are also increased, and the big amount of the consumption of the expensive phosphorescent dye is eliminated.

### Example 3

In order to test the influence of the host materials of the present invention on the performance of the organic electroluminescence device, in this Example an organic electroluminescence device is prepared by using the method the same as that of Example 1, and the structure of the luminescence device is as follows:
ITO (150nm)/NPB (40nm)/host material (the mass ratio of the two host materials is 1:1): 3% phosphorescent dye (Ir(ppy)₃) (30nm)/Bphen (20nm)/LiF (0.5nm)/Al (150nm).

The performance of the organic electroluminescence device is presented in Table 3:

**Table 3**

| Device | Luminescent Layer Structure | Luminescence Efficiency (cd/A) | Luminance (cd/m2) | External Quantum Efficiency (%) | Life T90 (hrs) |
|---|---|---|---|---|---|
| OLED3 | host material (thermally activated delayed fluorescence material 1-1, regulating host material niBr):phosphorescent dye | 45.1 | 5000 | 13.4 | 385 |
| OLED4 | host material (thermally activated delayed fluorescence material 1-10, regulating host material CBP):phosphorescent dye | 57.2 | 5000 | 17.6 | 510 |
| OLED5 | host material (thermally activated delayed fluorescence material 3-10, regulating host material TCTA):phosphorescent dye | 51.0 | 5000 | 15.7 | 497 |
| OLED6 | host material (thermally activated delayed fluorescence material 2-5, regulating host material mCP:phosphorescent dye:phosphorescent dye | 46.2 | 5000 | 14.2 | 387 |
| OLED7 | host material (thermally activated delayed fluorescence material 1-1, thermally activated delayed fluorescence material 3-1):phosphorescent dye | 54.6 | 5000 | 16.8 | 459 |
| OLED8 | host material (thermally activated delayed fluorescence material 1-2, thermally activated delayed fluorescence material 2-4):phosphorescent dye | 63.4 | 5000 | 19.5 | 513 |
| OLED9 | host material (thermally activated delayed fluorescence material 1-9, thermally activated delayed fluorescence material 3-4):phosphorescent dye | 48.7 | 5000 | 16.4 | 335 |
| OLED10 | host material (thermally activated delayed fluorescence material 1-14, thermally activated delayed fluorescence material 3-7):phosphorescent dye | 38.9 | 5000 | 14.7 | 412 |

The above examples are merely preferred examples that are presented to fully illustrate the present invention, and the protection scope of the present invention is not limited thereto. The protection scope of the present invention is limited by the claims.

## Claims

1. A thermally activated and sensitized phosphorescence organic electroluminescence device, comprising a luminescent layer, wherein, a host material of the luminescent layer consists of two materials, wherein one of the two materials is a hole transport material, the other is an electron transport material, and both of the two materials are thermally activated delayed fluorescence material; and the host material is doped by a phosphorescent dye, and a proportion of the phosphorescent dye in the luminescent layer is <15wt%, and
the triplet state energy level of the CT excited state of the thermally activated delayed fluorescence material is higher than the triplet state energy level of the n-π excited state by 0 to 0.3; or, the triplet state energy level of the CT excited state of the thermally activated delayed fluorescence material is higher than the triplet state energy level of the n-π excited state, wherein the difference is above 1.0eV, and, a difference between the second triplet state energy level of its n-π excited state and the first singlet state energy level of its CT excited state is-0.1 to 0.1eV.

2. The thermally activated and sensitized phosphorescence organic electroluminescence device according to claim 1, wherein, the proportion of the phosphorescent dye in the luminescent layer is 2wt%-10wt%.

3. The thermally activated and sensitized phosphorescence organic electroluminescence device according to claim 1, wherein, the proportion of the phosphorescent dye in the luminescent layer is 2wt%-3wt%.

4. The thermally activated and sensitized phosphorescence organic electroluminescence device according to claim 1, wherein, the thermally activated delayed fluorescence material is a material that has charge transfer transition, and the thermally activated delayed fluorescence material has both a donor group unit and an acceptor group unit therein,
the donor group unit is a donor group or a group that is formed by linking two or more donor groups;
the acceptor group unit is an acceptor group or a group that is formed by linking two or more acceptor groups;
the donor group is selected from indolocarbazolyl; carbazolyl; bicarbazolyl; trianilino; phenoxazinyl; indolocarbazolyl that is substituted by one or more groups of C₁₋₆ alkyl, methoxy, ethoxy or phenyl; carbazolyl that is substituted by one or more groups of C₁₋₆ alkyl, methoxy, ethoxy or phenyl; bicarbazolyl that is substituted by one or more groups of C₁₋₆ alkyl, methoxy, ethoxy or phenyl; trianilino that is substituted by one or more groups of C₁₋₆ alkyl, methoxy, ethoxy or phenyl; or phenoxazinyl that is substituted by one or more groups of C₁₋₆ alkyl, methoxy, ethoxy or phenyl; and
the acceptor group is selected from naphthyl; anthryl; phenanthryl; pyrenyl; triazinyl; benzimidazolyl; cyano; pyridinyl; sulfonyl; phenanthroimidazolyl; naphthathiazolyl; benzothiazolyl; oxadiazolyl; naphthyl that is substituted by one or more groups of C₁₋₆ alkyl, methoxy, ethoxy, phenyl or pyridinyl; anthryl that is substituted by one or more groups of C₁₋₆ alkyl, methoxy, ethoxy, phenyl or pyridinyl; phenanthryl that is substituted by one or more groups of C₁₋₆ alkyl, methoxy, ethoxy, phenyl or pyridinyl; pyrenyl that is substituted by one or more groups of C₁₋₆ alkyl, methoxy, ethoxy, phenyl or pyridinyl; triazinyl that is substituted by one or more groups of C₁₋₆ alkyl, methoxy, ethoxy, phenyl or pyridinyl; benzimidazolyl that is substituted by one or more groups of C₁₋₆ alkyl, methoxy, ethoxy, phenyl or pyridinyl; pyridinyl that is substituted by one or more groups of C₁₋₆ alkyl, methoxy, ethoxy, phenyl or pyridinyl; sulfonyl that is substituted by one or more groups of C₁₋₆ alkyl, methoxy, ethoxy, phenyl or pyridinyl; phenanthroimidazolyl that is substituted by one or more groups of C₁₋₆ alkyl, methoxy, ethoxy, phenyl or pyridinyl; naphthathiazolyl that is substituted by one or more groups of C₁₋₆ alkyl, methoxy, ethoxy, phenyl or pyridinyl; benzothiazolyl that is substituted by one or more groups of C₁₋₆ alkyl, methoxy, ethoxy, phenyl or pyridinyl; and oxadiazolyl that is substituted by one or more groups of C₁₋₆ alkyl, methoxy, ethoxy, phenyl or pyridinyl;
wherein, one or more of the donor group unit and one or more of the acceptor group unit directly link to form the thermally activated delayed fluorescence material; or, one or more of the donor group unit and one or more of the acceptor group unit individually link to a linking group to form the thermally activated delayed fluorescence material, wherein the linking group is a group that has a steric hindrance.

5. The thermally activated and sensitized phosphorescence organic electroluminescence device according to claim 4, wherein, one or two of the donor group units and one or two of the acceptor group units individually link to the linking group to form the thermally activated delayed fluorescence material, or one or two of the acceptor group units and one or two of the donor group units directly link to form the thermally activated delayed fluorescence material.

6. The thermally activated and sensitized phosphorescence organic electroluminescence device according to claim 4, wherein, the linking group is selected from spirofluorenyl; phenyl; biphenyl; spirofluorenyl that is substituted by at least one of C₁₋₆ alkyl or phenyl; phenyl that is substituted by at least one of C₁₋₆ alkyl or phenyl; and biphenyl that is substituted by at least one of C₁₋₆ alkyl or phenyl.

7. The thermally activated and sensitized phosphorescence organic electroluminescence device according to claim 4, wherein, the donor group is selected from the following groups:

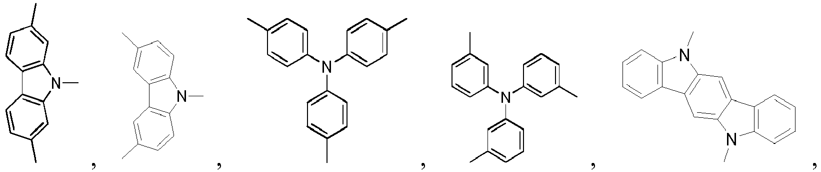

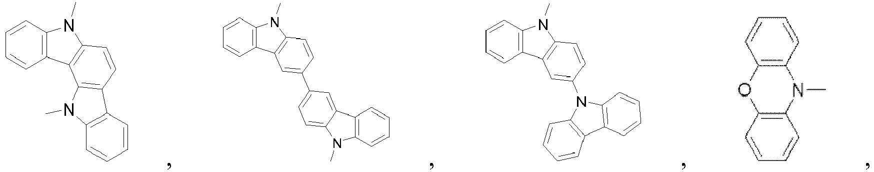

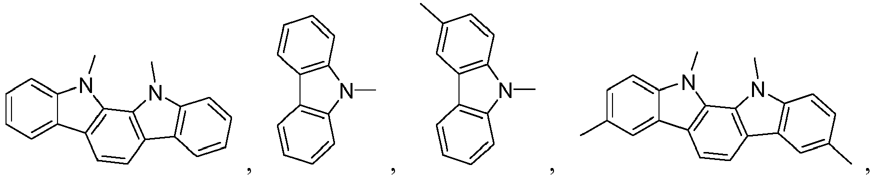

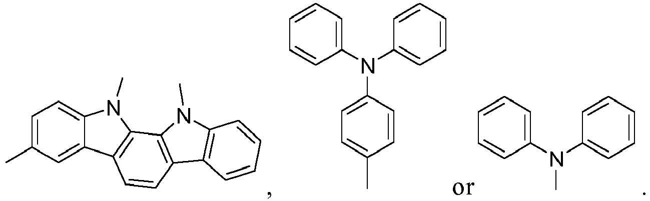

8. The thermally activated and sensitized phosphorescence organic electroluminescence device according to claim 4, wherein, the acceptor group is selected from the following groups:

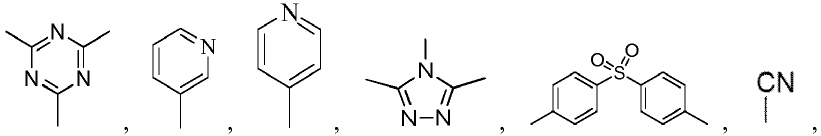

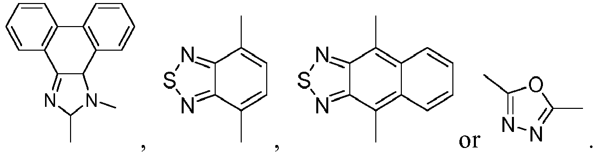

9. The thermally activated and sensitized phosphorescence organic electroluminescence device according to claim 4, wherein, the thermally activated delayed fluorescence material is a compound that has the following structures:

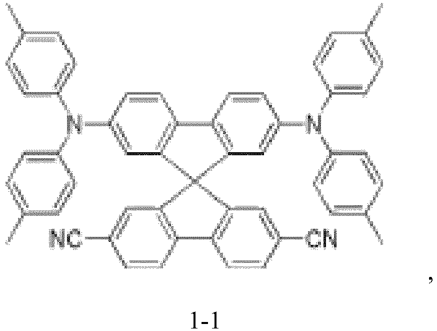

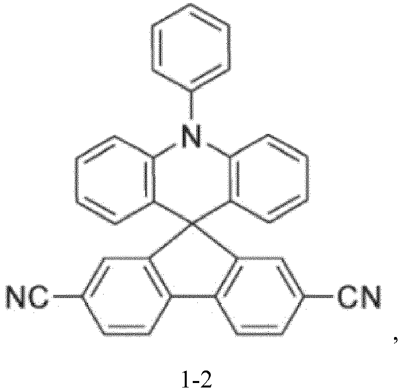

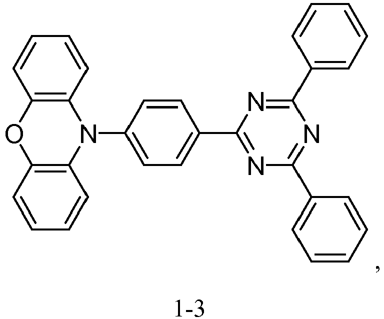

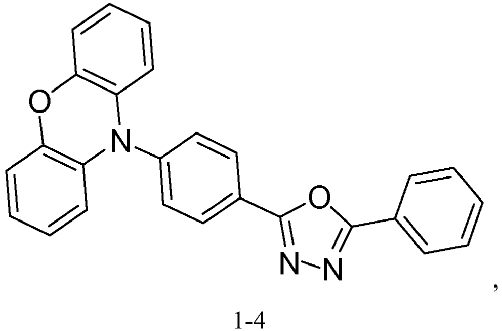

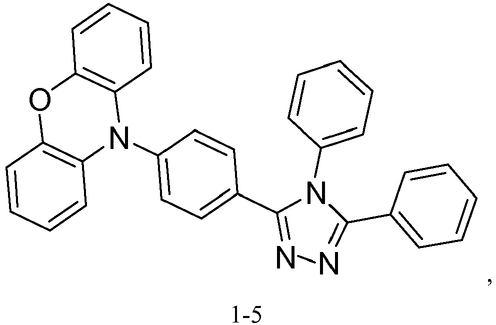

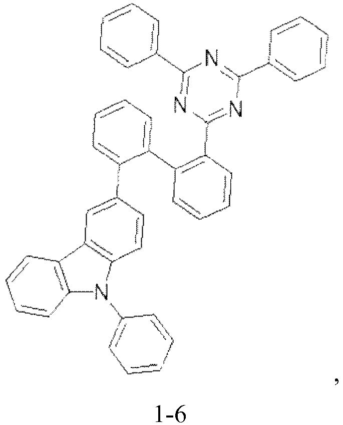

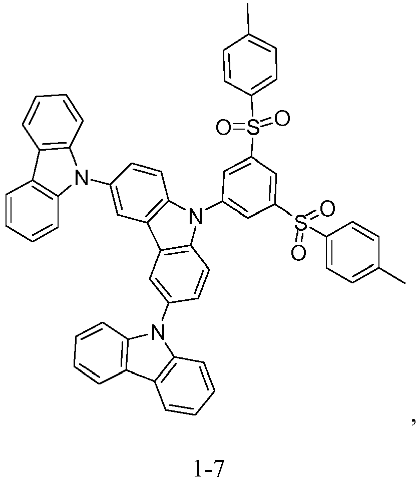

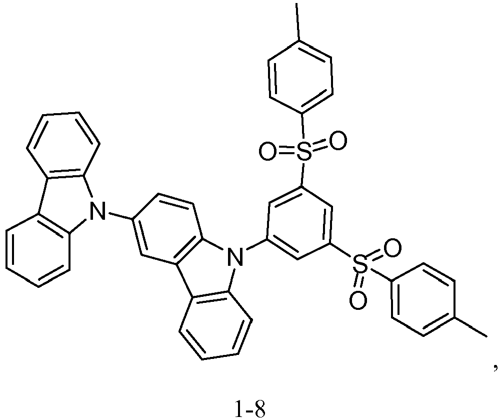

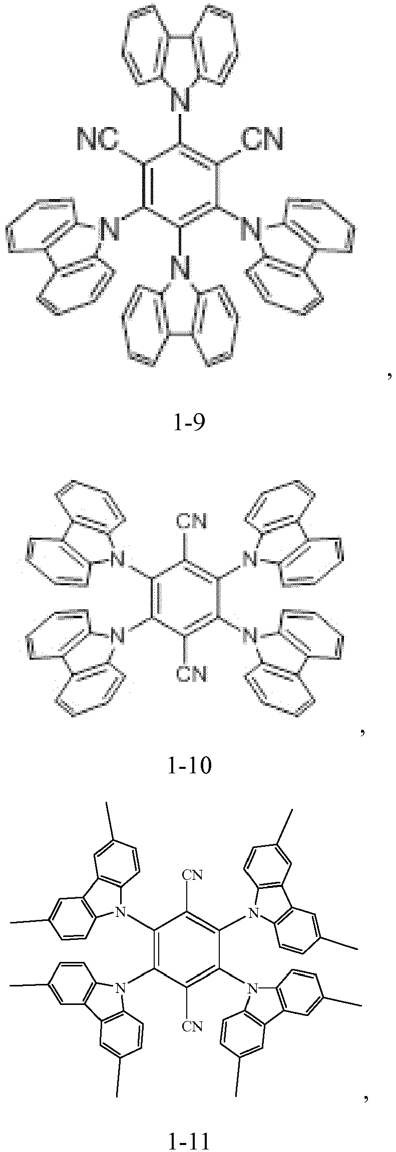

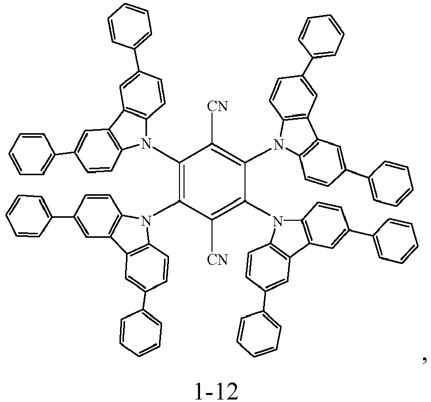

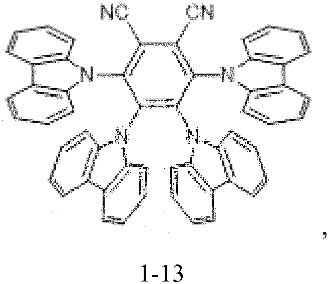

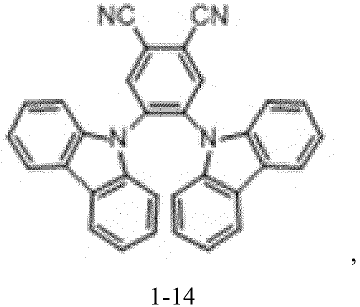

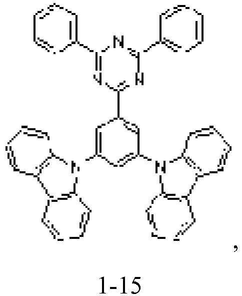

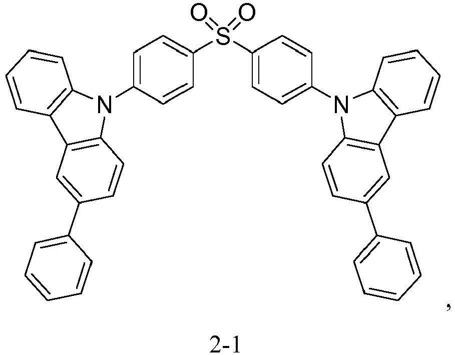

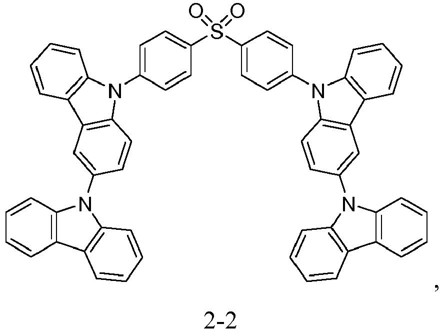

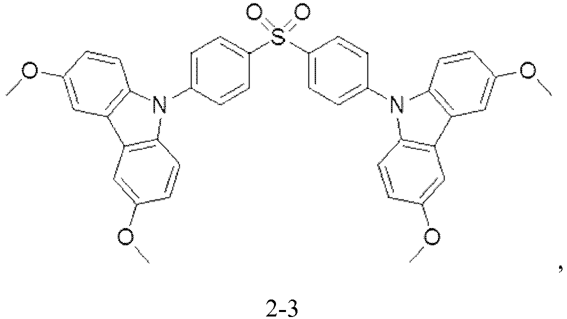

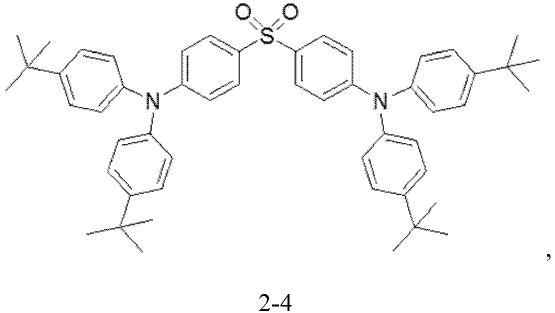

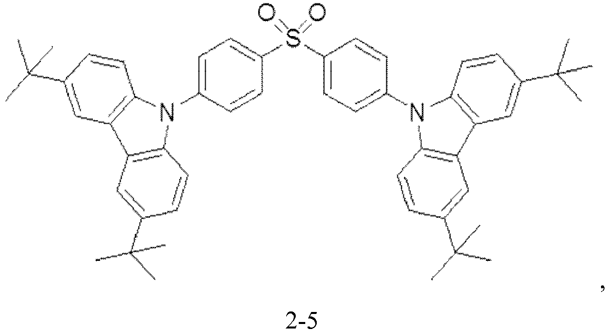

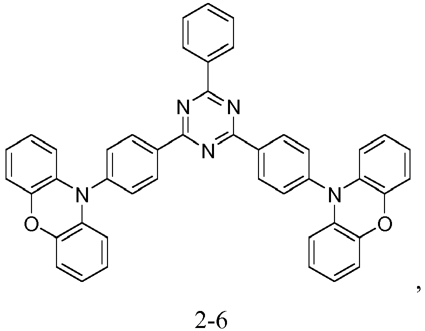

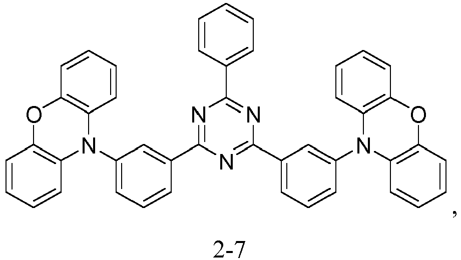

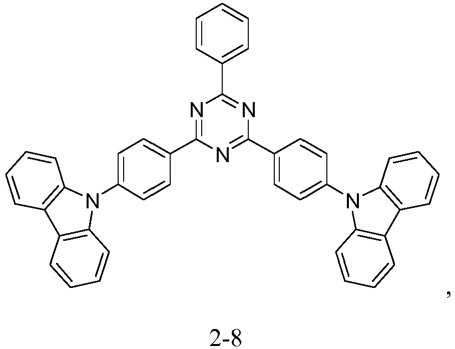

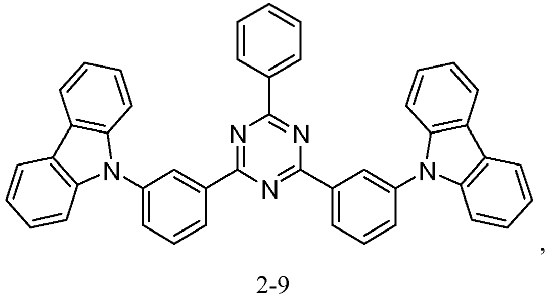

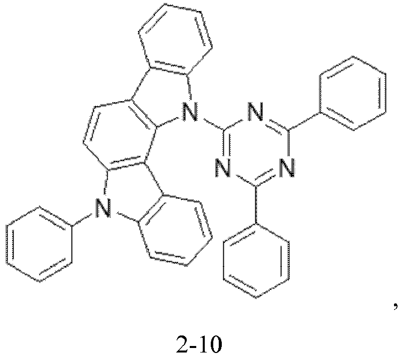

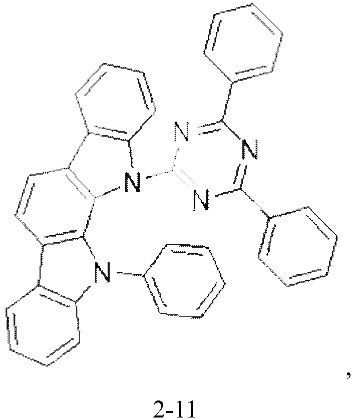

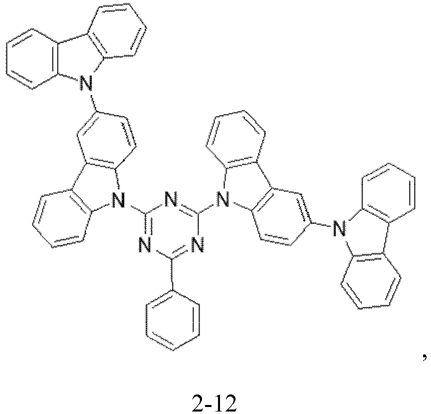

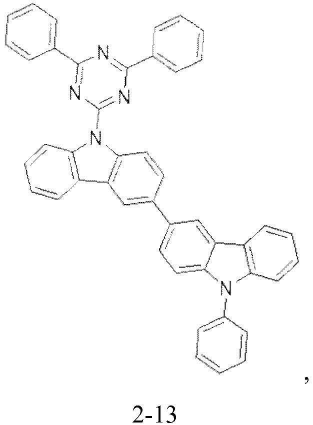

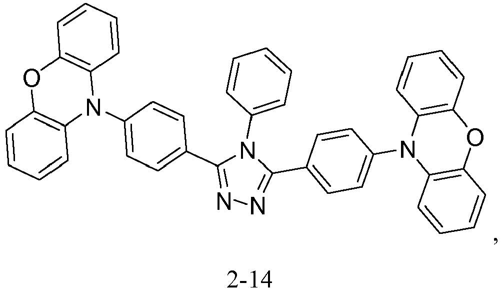

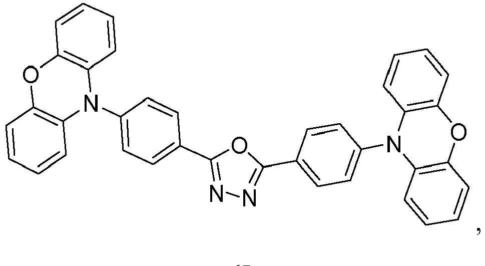

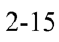

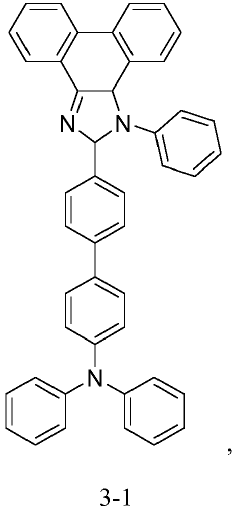

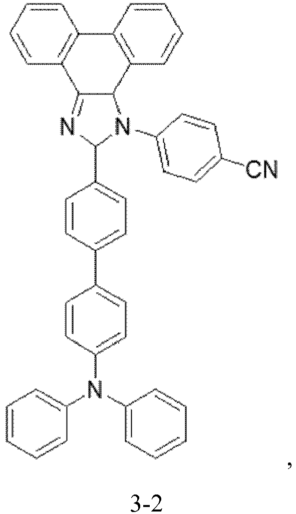

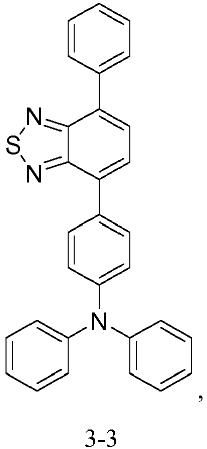

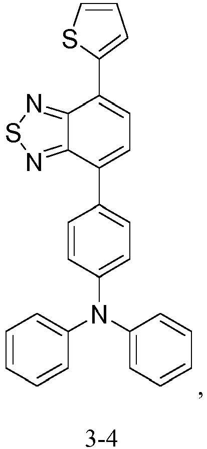

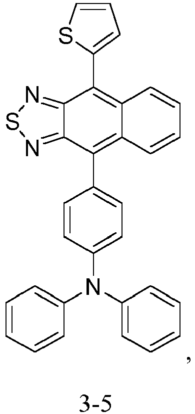

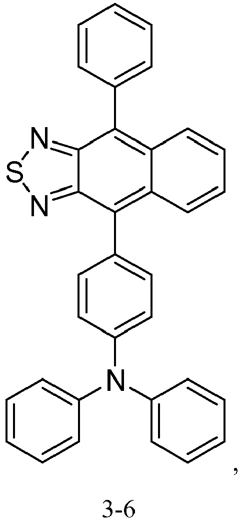

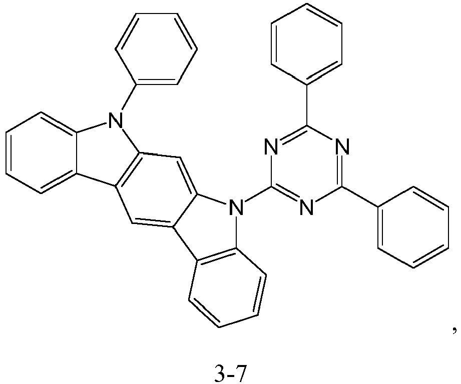

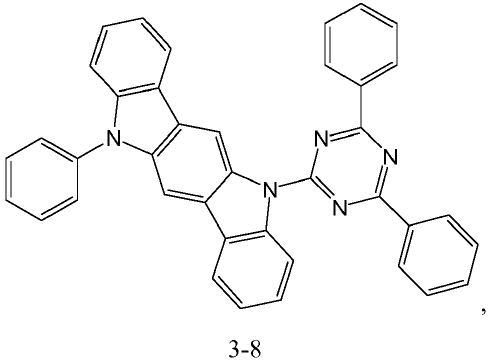

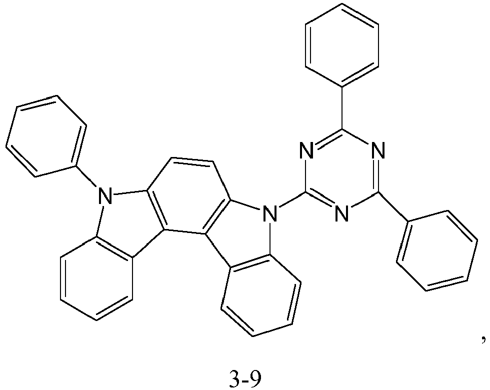

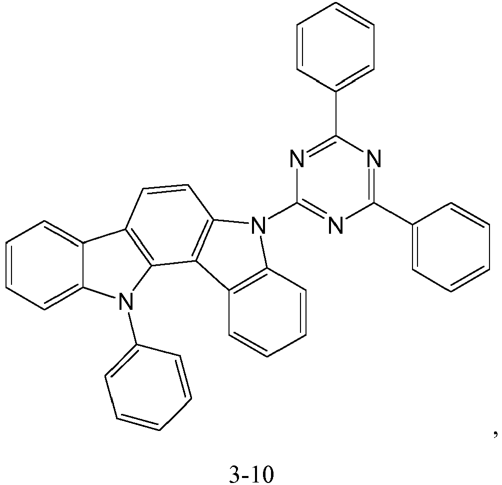

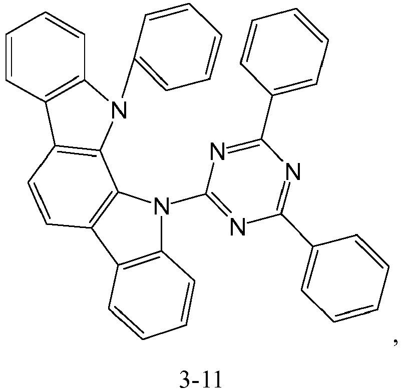

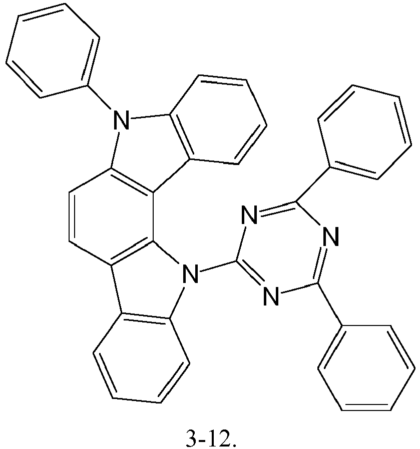

## Patentansprüche

1. Thermisch aktivierte und sensibilisierte, organische, phosphoreszierende Elektrolumineszenzvorrichtung, umfassend eine Lumineszenzschicht, wobei ein Wirtsmaterial der Lumineszenzschicht aus zwei Materialien besteht, wobei eines der beiden Materialien ein Lochtransportmaterial ist, das andere ein Elektronentransportmaterial ist und beide Materialien ein thermisch aktiviertes, verzögertes Fluoreszenzmaterial sind; und das Wirtsmaterial mit einem phosphoreszierenden Farbstoff dotiert ist, und ein Anteil des phosphoreszierenden Farbstoffs in der Lumineszenzschicht <15 Gew.-% beträgt, und
das Energieniveau des Triplettzustands des CT-angeregten Zustands des thermisch aktivierten, verzögerten Fluoreszenzmaterials um 0 bis 0,3 höher liegt als das Energieniveau des Triplettzustands des n-π-angeregten Zustand s; oder das Energieniveau des Triplettzustands des CT-angeregten Zustands des thermisch aktivierten, verzögerten Fluoreszenzmaterials höher als das Energieniveau des Triplettzustands des n-π-angeregten Zustands liegt, wobei die Differenz größer als 1,0 eV ist, und eine Differenz zwischen dem zweiten Energieniveau des Triplettzustands seines n-π-angeregten Zustands und dem ersten Energieniveau des Singulettzustands seines CT-angeregten Zustands -0,1 bis 0,1 eV beträgt.

2. Thermisch aktivierte und sensibilisierte, organische, phosphoreszierende Elektrolumineszenzvorrichtung nach Anspruch 1, wobei der Anteil des phosphoreszierenden Farbstoffs in der Lumineszenzschicht 2 Gew.-% bis 10 Gew.-% beträgt.

3. Thermisch aktivierte und sensibilisierte, organische, phosphoreszierende Elektrolumineszenzvorrichtung nach Anspruch 1, wobei der Anteil des phosphoreszierenden Farbstoffs in der Lumineszenzschicht 2 Gew.-% bis 3 Gew.-% beträgt.

4. Thermisch aktivierte und sensibilisierte, organische, phosphoreszierende Elektrolumineszenzvorrichtung nach Anspruch 1, wobei das thermisch aktivierte, verzögerte Fluoreszenzmaterial ein Material ist, das einen Charge-Transfer-Übergang aufweist, und das thermisch aktivierte, verzögerte Fluoreszenzmaterial sowohl eine Donorgruppeneinheit als auch eine Akzeptorgruppeneinheit darin aufweist,
die Donorgruppeneinheit eine Donorgruppe oder eine Gruppe ist, die durch die Verknüpfung von zwei oder mehreren Donorgruppen gebildet wird;
die Akzeptorgruppeneinheit eine Akzeptorgruppe oder eine Gruppe ist, die durch Verknüpfen von zwei oder mehreren Akzeptorgruppen gebildet wird;
die Donorgruppe ausgewählt ist aus Indolocarbazolyl, Carbazolyl, Bicarbazolyl, Trianilino, Phenoxazinyl; Indolocarbazolyl, das durch eine oder mehrere Gruppen aus C₁₋₆-Alkyl, Methoxy, Ethoxy oder Phenyl substituiert ist; Carbazolyl, das durch eine oder mehrere Gruppen aus C₁₋₆-Alkyl, Methoxy, Ethoxy oder Phenyl substituiert ist; Bicarbazolyl, das durch eine oder mehrere Gruppen aus C₁₋₆-Alkyl, Methoxy, Ethoxy oder Phenyl substituiert ist; Trianilino, das durch eine oder mehrere Gruppen aus C₁₋₆-Alkyl, Methoxy, Ethoxy oder Phenyl substituiert ist; oder Phenoxazinyl, das durch eine oder mehrere Gruppen aus C₁₋₆-Alkyl, Methoxy, Ethoxy oder Phenyl substituiert ist; und
die Akzeptorgruppe ausgewählt ist aus Naphthyl, Anthryl, Phenanthryl, Pyrenyl, Triazinyl, Benzimidazolyl, Cyano, Pyridinyl, Sulfonyl, Phenanthroimidazolyl, Naphthathiazolyl, Benzothiazolyl, Oxadiazolyl; Naphthyl, das durch eine oder mehrere Gruppen aus C₁₋₆-Alkyl, Methoxy, Ethoxy, Phenyl oder Pyridinyl substituiert ist; Anthryl, das durch eine oder mehrere Gruppen aus C₁₋₆-Alkyl, Methoxy, Ethoxy, Phenyl oder Pyridinyl substituiert ist; Phenanthryl, das durch eine oder mehrere Gruppen aus C₁₋₆-Alkyl, Methoxy, Ethoxy, Phenyl oder Pyridinyl substituiert ist; Pyrenyl, das durch eine oder mehrere Gruppen aus C₁₋₆-Alkyl, Methoxy, Ethoxy, Phenyl oder Pyridinyl substituiert ist; Triazinyl, das durch eine oder mehrere Gruppen aus C₁₋₆-Alkyl, Methoxy, Ethoxy, Phenyl oder Pyridinyl substituiert ist; Benzimidazolyl, das durch eine oder mehrere Gruppen aus C₁₋₆-Alkyl, Methoxy, Ethoxy, Phenyl oder Pyridinyl substituiert ist; Pyridinyl, das durch eine oder mehrere Gruppen aus C₁₋₆-Alkyl, Methoxy, Ethoxy, Phenyl oder Pyridinyl substituiert ist; Sulfonyl, das durch eine oder mehrere Gruppen aus C₁₋₆-Alkyl, Methoxy, Ethoxy, Phenyl oder Pyridinyl substituiert ist; Phenanthroimidazolyl, das durch eine oder mehrere Gruppen aus C₁₋₆-Alkyl, Methoxy, Ethoxy, Phenyl oder Pyridinyl substituiert ist; Naphthathiazolyl, das durch eine oder mehrere Gruppen aus C₁₋₆-Alkyl, Methoxy, Ethoxy, Phenyl oder Pyridinyl substituiert ist; Benzothiazolyl, das durch eine oder mehrere Gruppen aus C₁₋₆-Alkyl, Methoxy, Ethoxy, Phenyl oder Pyridinyl substituiert ist; und Oxadiazolyl, das durch eine oder mehrere Gruppen aus C₁₋₆-Alkyl, Methoxy, Ethoxy, Phenyl oder Pyridinyl substituiert ist;
wobei eine oder mehrere der Donorgruppeneinheit und eine oder mehrere der Akzeptorgruppeneinheit direkt miteinander verknüpft sind, um das thermisch aktivierte, verzögerte Fluoreszenzmaterial zu bilden; oder eine oder mehrere der Donorgruppeneinheit und eine oder mehrere der Akzeptorgruppeneinheit einzeln mit einer Verknüpfungsgruppe verknüpft sind, um das thermisch aktivierte, verzögerte Fluoreszenzmaterial zu bilden, wobei die Verknüpfungsgruppe eine Gruppe ist, die eine sterische Hinderung aufweist.

5. Thermisch aktivierte und sensibilisierte, organische, phosphoreszierende Elektrolumineszenzvorrichtung nach Anspruch 4, wobei eine oder zwei der Donorgruppeneinheiten und eine oder zwei der Akzeptorgruppeneinheiten einzeln mit der Verknüpfungsgruppe verknüpft sind, um das thermisch aktivierte, verzögerte Fluoreszenzmaterial zu bilden, oder eine oder zwei der Akzeptorgruppeneinheiten und eine oder zwei der Donorgruppeneinheiten direkt miteinander verknüpft sind, um das thermisch aktivierte, verzögerte Fluoreszenzmaterial zu bilden.

6. Thermisch aktivierte und sensibilisierte, organische, phosphoreszierende Elektrolumineszenzvorrichtung nach Anspruch 4, worin die Verknüpfungsgruppe ausgewählt ist aus Spirofluorenyl; Phenyl; Biphenyl; Spirofluorenyl, das durch mindestens eines aus C₁₋₆-Alkyl oder Phenyl substituiert ist; Phenyl, das durch mindestens eines aus C₁₋₆-Alkyl oder Phenyl substituiert ist; und Biphenyl, das durch mindestens eines aus C₁₋₆-Alkyl oder Phenyl substituiert ist.

7. Thermisch aktivierte und sensibilisierte, organische, phosphoreszierende Elektrolumineszenzvorrichtung nach Anspruch 4, worin die Donorgruppe aus den folgenden Gruppen ausgewählt ist:

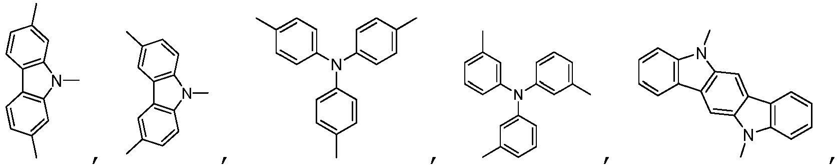

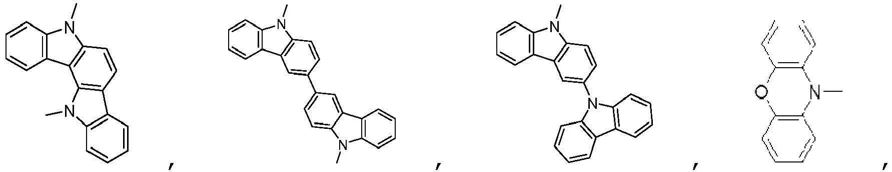

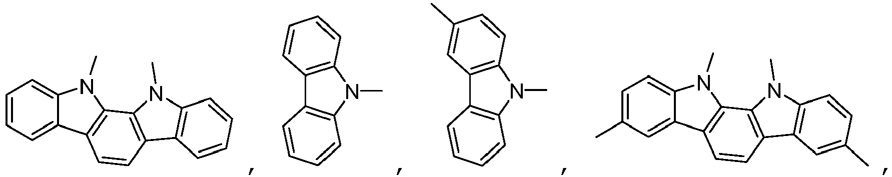

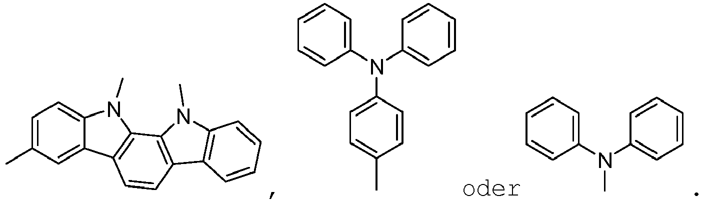

8. Thermisch aktivierte und sensibilisierte, organische, phosphoreszierende Elektrolumineszenzvorrichtung nach Anspruch 4, worin die Akzeptorgruppe aus den folgenden Gruppen ausgewählt ist:

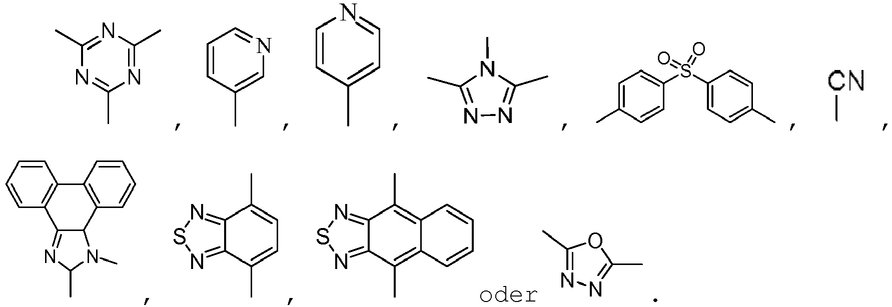

9. Thermisch aktivierte und sensibilisierte, organische, phosphoreszierende Elektrolumineszenzvorrichtung nach Anspruch 4, wobei das thermisch aktivierte, verzögerte Fluoreszenzmaterial eine Verbindung ist, die die folgenden Strukturen aufweist:

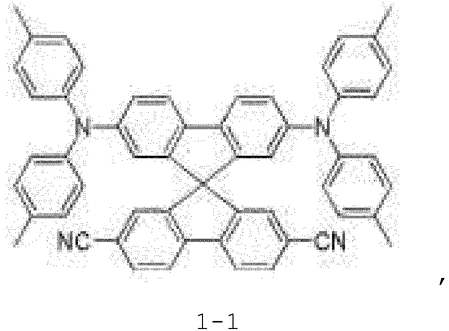

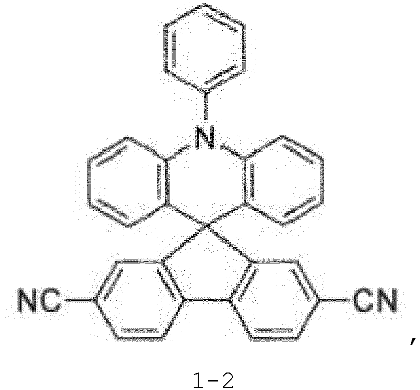

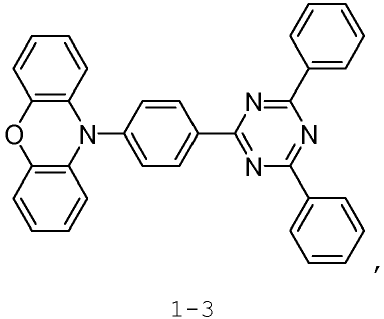

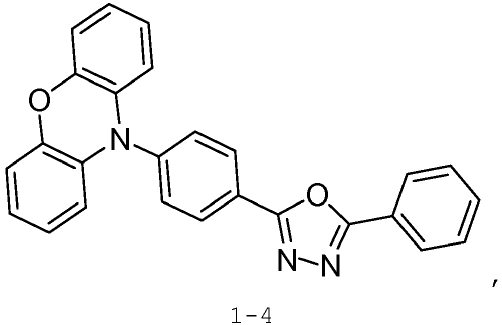

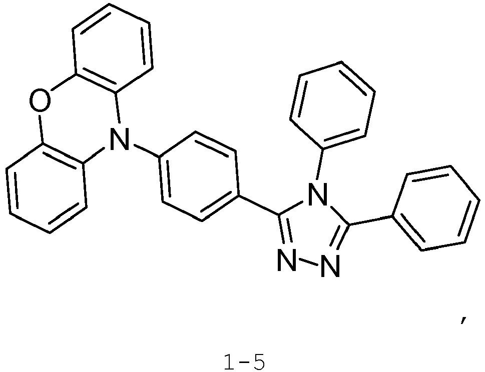

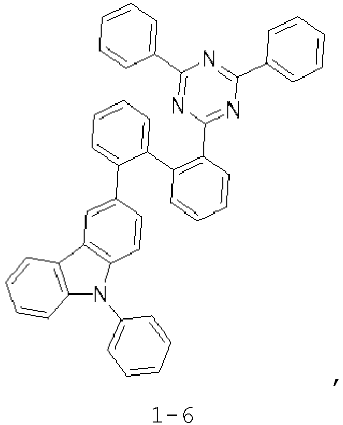

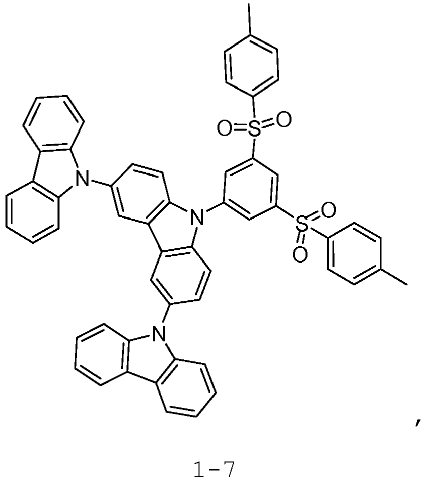

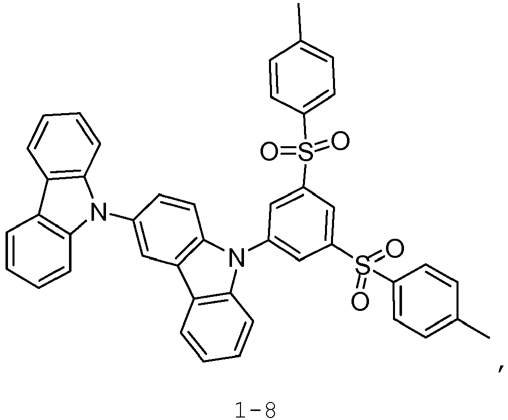

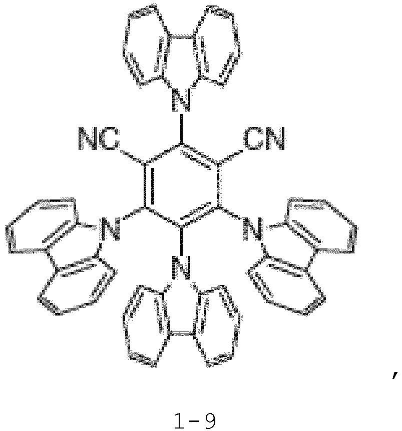

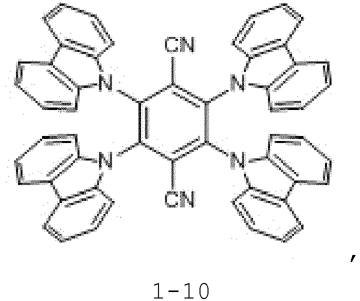

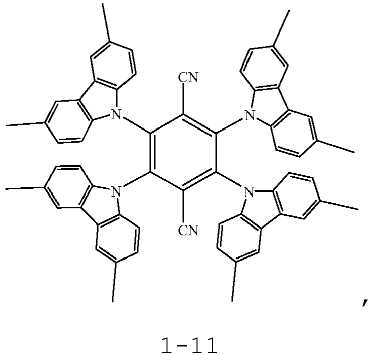

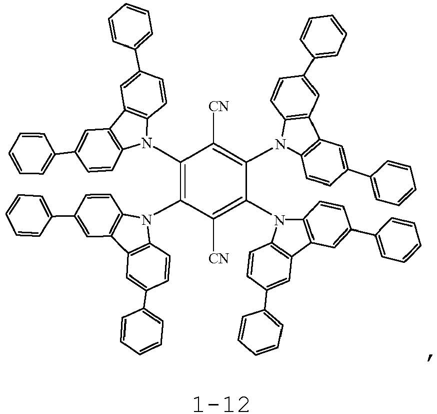

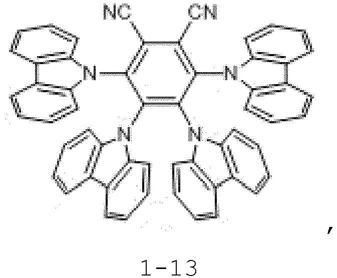

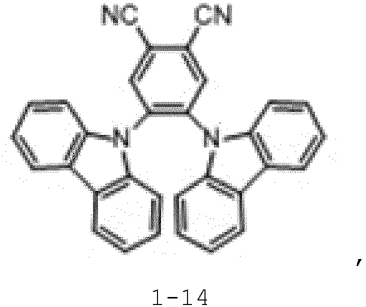

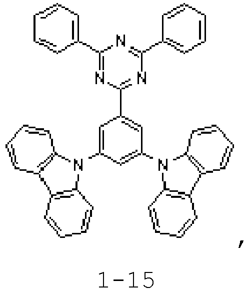

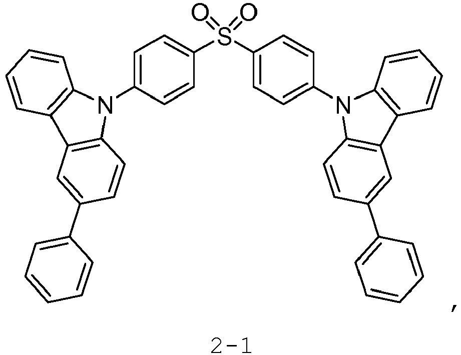

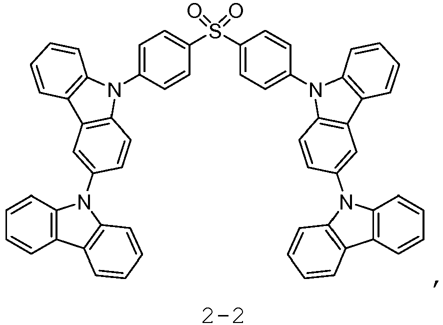

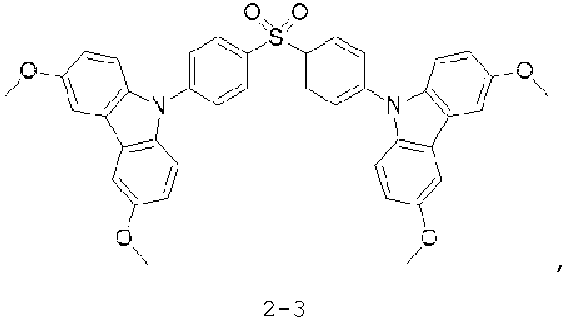

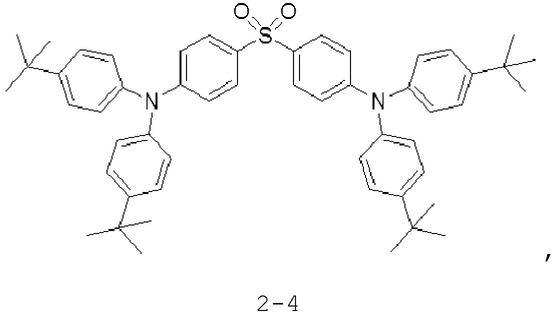

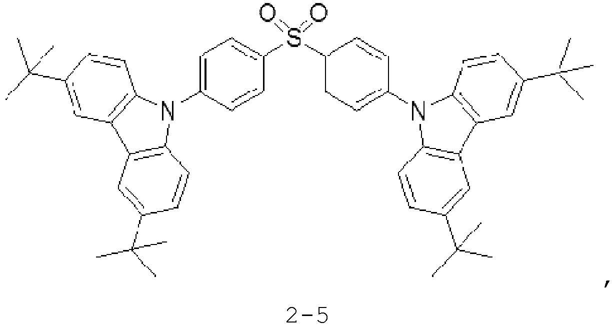

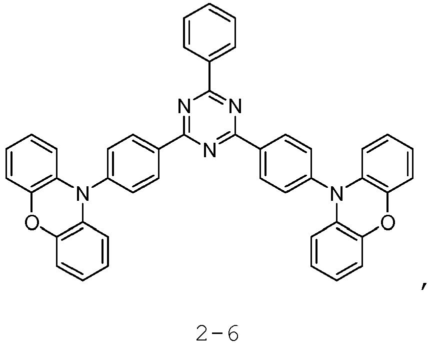

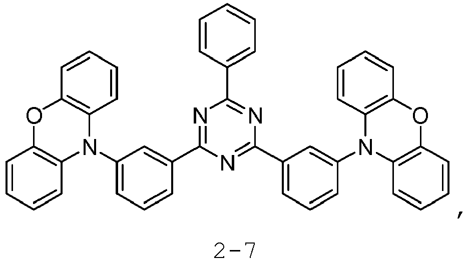

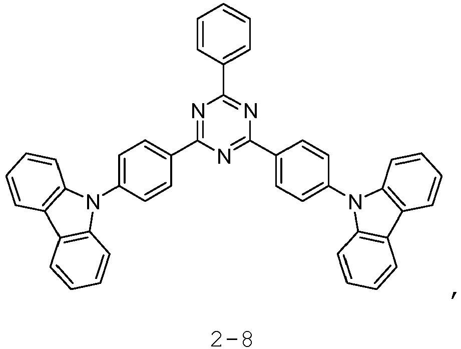

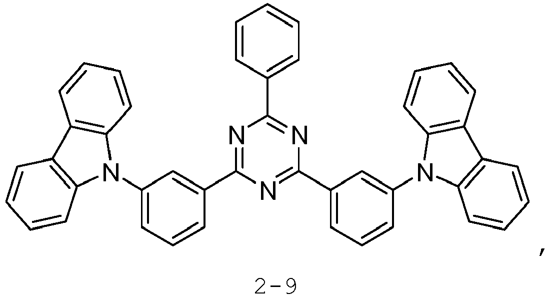

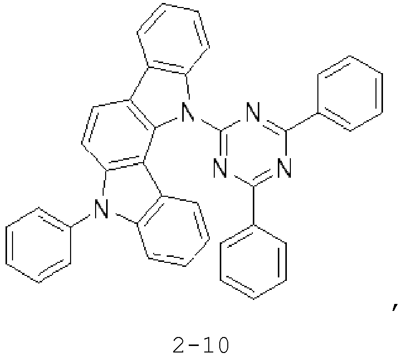

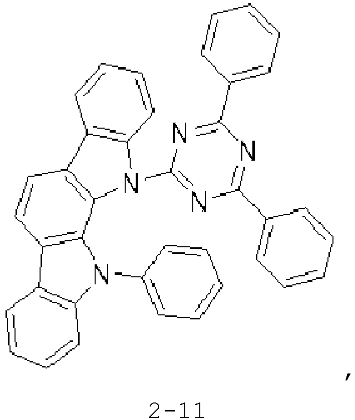

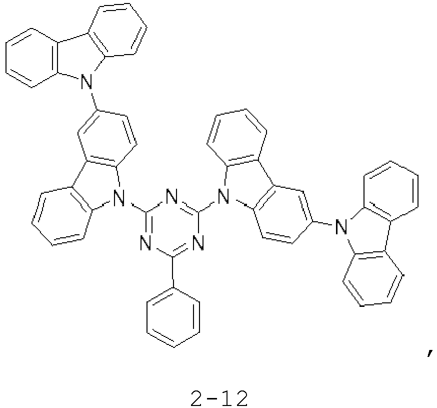

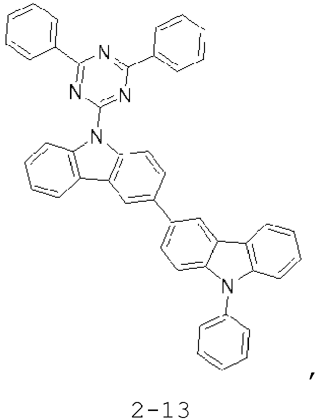

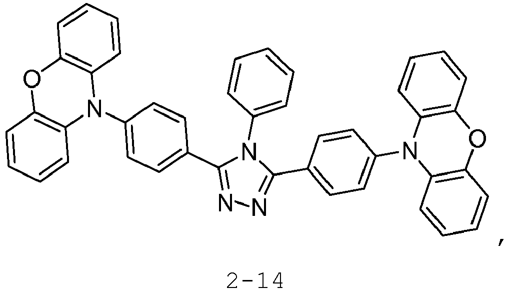

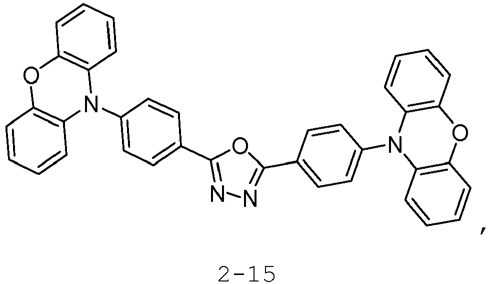

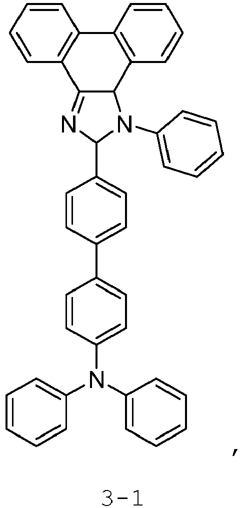

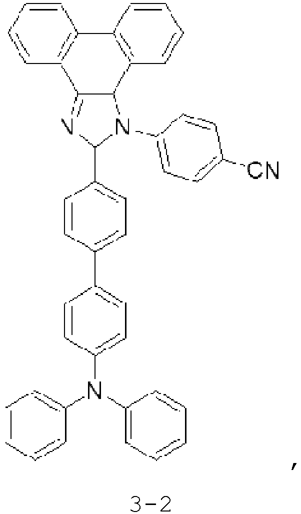

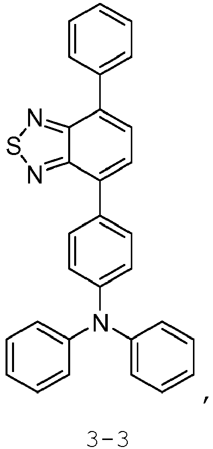

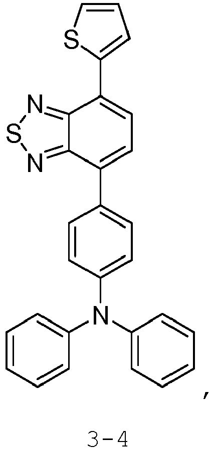

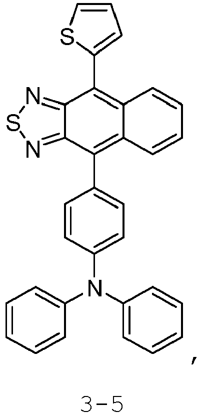

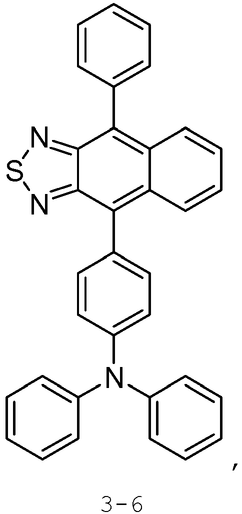

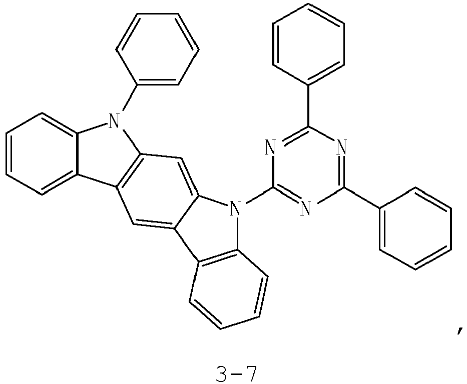

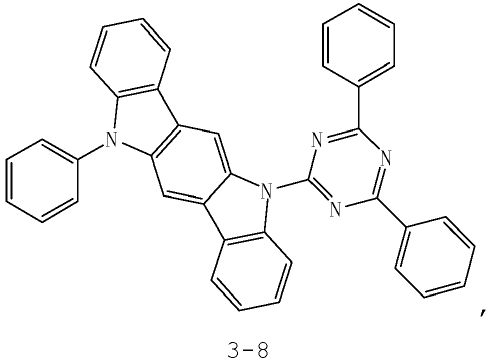

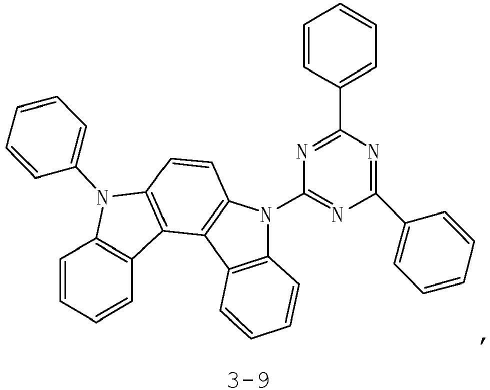

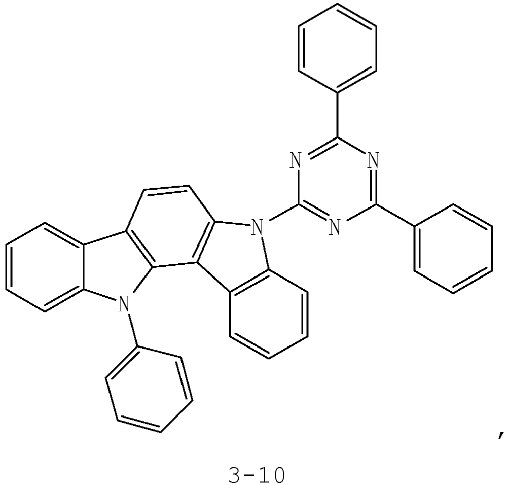

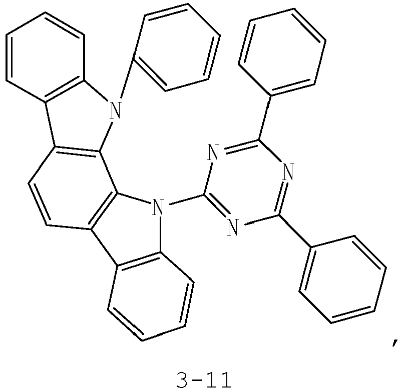

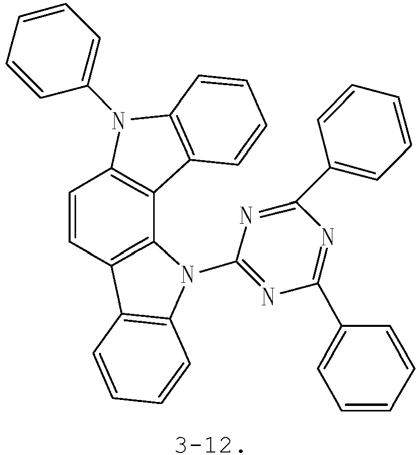

## Revendications

1. Dispositif à électroluminescence organique à phosphorescence activée thermiquement et sensibilisée, comprenant une couche luminescente, dans lequel une matière hôte de la couche luminescente consiste en deux matières, l'une des deux matières étant une matière de transport de trous, l'autre étant une matière de transport d'électrons, et les deux matières étant une matière à fluorescence retardée activée thermiquement ; et la matière hôte étant dopée par un colorant phosphorescent, et une proportion du colorant phosphorescent dans la couche luminescente étant < 15 % en poids, et
le niveau d'énergie d'état triplet de l'état excité CT de la matière à fluorescence retardée activée thermiquement est supérieur au niveau d'énergie d'état triplet de l'état excité n-π de 0 à 0,3 ; ou le niveau d'énergie d'état triplet de l'état excité CT de la matière à fluorescence retardée activée thermiquement est supérieur au niveau d'énergie d'état triplet de l'état excité n-π, la différence étant supérieure à 1,0 eV, et une différence entre le second niveau d'énergie d'état triplet de son état excité n-π et le premier niveau d'énergie d'état singulet de son état excité CT est -0,1 à 0,1 eV.

2. Dispositif à électroluminescence organique à phosphorescence activée thermiquement et sensibilisée, selon la revendication 1, dans lequel la proportion du colorant phosphorescent dans la couche luminescente est de 2 % en poids-10 % en poids.

3. Dispositif à électroluminescence organique à phosphorescence activée thermiquement et sensibilisée, selon la revendication 1, dans lequel la proportion du colorant phosphorescent dans la couche luminescente est de 2 % en poids-3 % en poids.

4. Dispositif à électroluminescence organique à phosphorescence activée thermiquement et sensibilisée, selon la revendication 1, dans lequel la matière à fluorescence retardée activée thermiquement est une matière qui a une transition de transfert de charge, et la matière à fluorescence retardée activée thermiquement présente à la fois une unité à groupe donneur et une unité à groupe accepteur dans celle-ci,
l'unité à groupe donneur est un groupe donneur ou un groupe qui est formé par liaison d'au moins deux groupes donneurs ;
l'unité à groupe accepteur est un groupe accepteur ou un groupe qui est formé par liaison d'au moins deux groupes accepteurs ;
le groupe donneur est choisi parmi indolocarbazolyle ; carbazolyle ; bicarbazolyle ; trianilino ; phénoxazinyle ; indolocarbazolyle qui est substitué par un ou plusieurs groupes d'alkyle en C₁₋₆, méthoxy, éthoxy ou phényle ; carbazolyle qui est substitué par un ou plusieurs groupes d'alkyle en C₁₋₆, méthoxy, éthoxy ou phényle ; bicarbazolyle qui est substitué par un ou plusieurs groupes d'alkyle en C₁₋₆, méthoxy, éthoxy ou phényle ; trianilino qui est substitué par un ou plusieurs groupes d'alkyle en C₁₋₆, méthoxy, éthoxy ou phényle ; ou phénoxazinyle qui est substitué par un ou plusieurs groupes d'alkyle en C₁₋₆, méthoxy, éthoxy ou phényle ; et
le groupe accepteur est choisi parmi naphtyle ; anthryle ; phénanthryle ; pyrényle ; triazinyle ; benzimidazolyle ; cyano ; pyridinyle ; sulfonyle ; phénanthroimidazolyle ; naphtathiazolyle ; benzothiazolyle ; oxadiazolyle ; naphtyle qui est substitué par un ou plusieurs groupes d'alkyle en C₁₋₆, méthoxy, éthoxy, phényle ou pyridinyle ; anthryle qui est substitué par un ou plusieurs groupes d'alkyle en C₁₋₆, méthoxy, éthoxy, phényle ou pyridinyle ; phénanthryle qui est substitué par un ou plusieurs groupes d'alkyle en C₁₋₆, méthoxy, éthoxy, phényle ou pyridinyle ; pyrényle qui est substitué par un ou plusieurs groupes d'alkyle en C₁₋₆, méthoxy, éthoxy, phényle ou pyridinyle ; triazinyle qui est substitué par un ou plusieurs groupes d'alkyle en C₁₋₆, méthoxy, éthoxy, phényle ou pyridinyle ; benzimidazolyle qui est substitué par un ou plusieurs groupes d'alkyle en C₁₋₆, méthoxy, éthoxy, phényle ou pyridinyle ; pyridinyle qui est substitué par un ou plusieurs groupes d'alkyle en C₁₋₆, méthoxy, éthoxy, phényle ou pyridinyle ; sulfonyle qui est substitué par un ou plusieurs groupes d'alkyle en C₁₋₆, méthoxy, éthoxy, phényle ou pyridinyle ; phénanthroimidazolyle qui est substitué par un ou plusieurs groupes d'alkyle en C₁₋₆, méthoxy, éthoxy, phényle ou pyridinyle ; naphtathiazolyle qui est substitué par un ou plusieurs groupes d'alkyle en C₁₋₆, méthoxy, éthoxy, phényle ou pyridinyle ; benzothiazolyle qui est substitué par un ou plusieurs groupes d'alkyle en C₁₋₆, méthoxy, éthoxy, phényle ou pyridinyle ; et oxadiazolyle qui est substitué par un ou plusieurs groupes d'alkyle en C₁₋₆, méthoxy, éthoxy, phényle ou pyridinyle ;
dans lequel une ou plusieurs de l'unité à groupe donneur et une ou plusieurs de l'unité à groupe accepteur sont liées directement pour former la matière à fluorescence retardée activée thermiquement ; ou une ou plusieurs de l'unité à groupe donneur et une ou plusieurs de l'unité à groupe accepteur sont liées individuellement à un groupe de liaison pour former la matière à fluorescence retardée activée thermiquement, le groupe de liaison étant un groupe qui a un encombrement stérique.

5. Dispositif à électroluminescence organique à phosphorescence activée thermiquement et sensibilisée, selon la revendication 4, dans lequel une ou deux des unités à groupe donneur et une ou deux des unités à groupe accepteur sont liées individuellement au groupe de liaison pour former la matière à fluorescence retardée activée thermiquement, ou une ou deux des unités à groupe accepteur et une ou deux des unités à groupe donneur sont liées directement pour former la matière à fluorescence retardée activée thermiquement.

6. Dispositif à électroluminescence organique à phosphorescence activée thermiquement et sensibilisée, selon la revendication 4, dans lequel le groupe de liaison est choisi parmi spirofluorényle ; phényle ; biphényle ; spirofluorényle qui est substitué par au moins l'un d'alkyle en C₁₋₆ ou phényle ; phényle qui est substitué par au moins l'un d'alkyle en C₁₋₆ ou phényle ; et biphényle qui est substitué par au moins l'un d'alkyle en C₁₋₆ ou phényle.

7. Dispositif à électroluminescence organique à phosphorescence activée thermiquement et sensibilisée, selon la revendication 4, dans lequel, le groupe donneur est choisi parmi les groupes suivants :

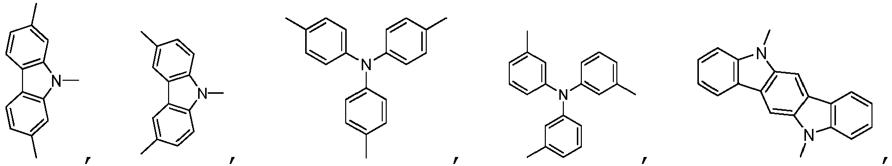

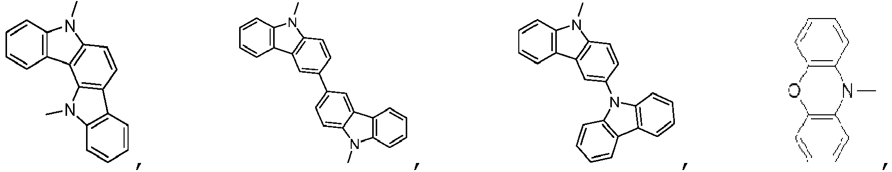

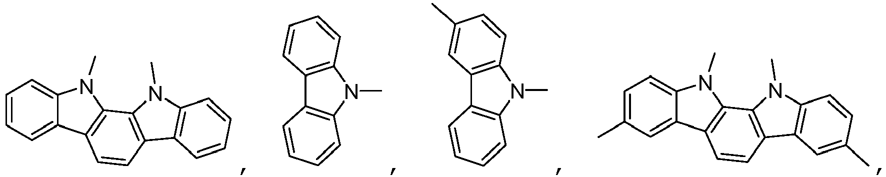

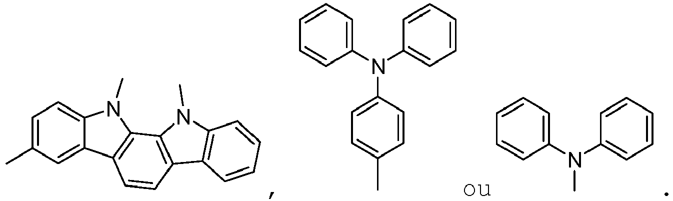

8. Dispositif à électroluminescence organique à phosphorescence activée thermiquement et sensibilisée, selon la revendication 4, dans lequel, le groupe accepteur est choisi parmi les groupes suivants :

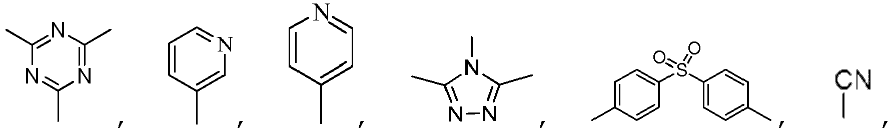

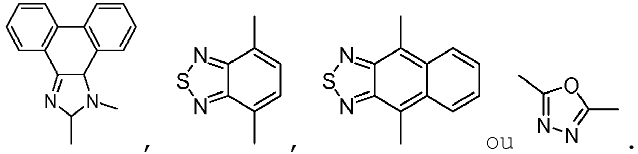

9. Dispositif à électroluminescence organique à phosphorescence activée thermiquement et sensibilisée, selon la revendication 4, dans lequel la matière à fluorescence retardée activée thermiquement est un composé qui a les structures suivantes :
